# EUROPEAN PATENT SPECIFICATION

(11) **EP 1 960 493 B1**
(45) Date of publication and mention of the grant of the patent: **05.01.2011**
(21) Application number: 06823676.9
(22) Date of filing: 22.11.2006
(51) Int. Cl.: C09K 11/06, H05B 33/14

(54) **ORGANIC ELECTROLUMINESCENT COMPOUNDS AND DISPLAY DEVICE USING THE SAME**
ORGANISCHE ELEKTROLUMINESZENZVERBINDUNGEN UND DAVON GEBRAUCH MACHENDE ANZEIGEVORRICHTUNG
COMPOSES ELECTROLUMINESCENTS ORGANIQUES ET DISPOSITIF D'AFFICHAGE FAISANT APPEL A CES COMPOSES

(30) Priority: 22.11.2005 KR 20050112046; 21.11.2006 KR 20060115344
(43) Date of publication of application: 27.08.2008
(73) Proprietor: Gracel Display Inc., Seoul 133-833 (KR)
(72) Inventor: KWON, Hyuck-Joo, Seoul 121-070 (KR); CHO, Young-Jun, Seoul 132-739 (KR); YOON, Seung-Soo, Seoul 135-884 (KR); KIM, Bong-Ok, Seoul 143-150 (KR); KIM, Sung-Min, Seoul 157-886 (KR)
(74) Representative: Albrecht, Thomas
(86) International application number: PCT/KR2006/004922
(87) International publication number: WO 2007/061218

(56) References cited:
- EP-A- 1 491 568
- EP-A2- 1 220 339
- WO-A-2004/020372
- JP-A- 2000 012 228
- JP-A- 2002 326 965
- JP-A- 2004 083 481
- US-A1- 2002 132 134
- US-A1- 2004 063 981

## Description

### [Field of the Invention]

The present invention relates to novel organic electroluminescent compounds
and display devices employing the same as an electroluminescent material.

### [Background of the Related Art]

The most important issue in developing an organic electroluminescent device having high efficiency and long life is development of electroluminescent material of high performance. In view of current development of electroluminescent material, it is the fact that red or blue electroluminescent materials show even lower electroluminescent property as compared to green electroluminescent materials. In order to realize a full color display, three electroluminescent materials (red, green and blue) are employed, and the material having the lowest property among the three materials eventually determines the performance of the entire panel. Thus, development of blue or red electroluminescent material having high efficient and long life is an important matter to enhance the properties of an entire organic electroluminescent device.

As a blue electroluminescent material, diphenylanthracene, tetraphenylbutadiene, distyrylbenzene derivatives and the like have been developed, but the compounds have been known to have low stability of thin film so that they tend to be readily crystallized. Diphenyldistyryl type blue electroluminescent materials having improved stability of thin film where the phenyl group of side chain inhibits crystallization have been developed by Idemitsu [H. Takailin, H. Higashi, C. Hosokawa, EP 388,768 (1990) ]. Distyrylanthracene derivatives having improved stability of thin film due to electron withdrawers and electron donors have been developed by Kyushu University [Pro. SPIE, 1910, 180 (1993)].

In addition, DPVBi of Chemical Formula A from Idemitsu Kosan, arylethylene derivatives such as DPVDPAN of Chemical Formula B, dinaphthylanthracene of Chemical Formula C from Kodak Company and tetra(t-butyl)perylene system of Chemical Formula D, as disclosed in EP 1063869 A1 (Idemitsu Kosan Company Limited), Korean Patent Laid-Open 2000-0048006 (Eastman Kodak Company, USA) and Japanese Patent Laid-Open 1996-333569, have been widely used as blue electroluminescent materials.

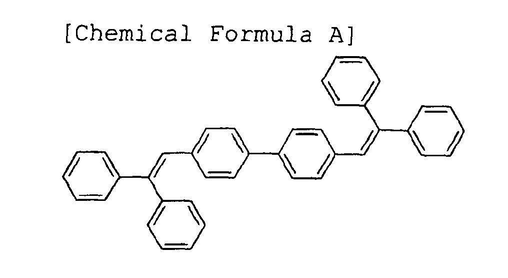

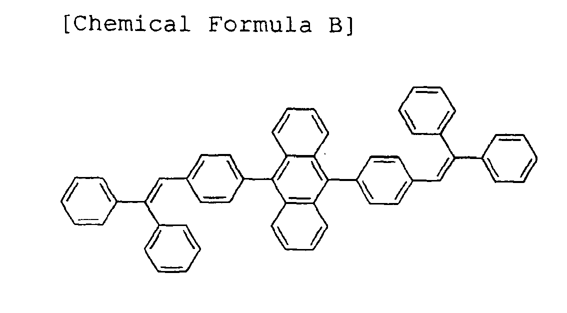

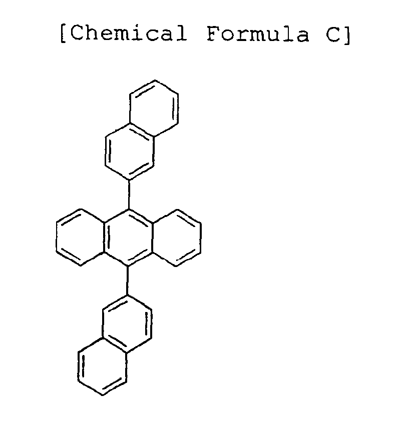

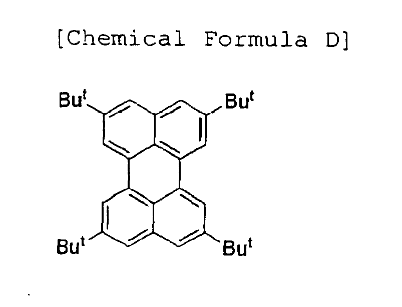

Since DPVBi of Chemical Formula A involves problem of thermal stability having low glass transition temperature of 100°C or less, DPVDPAN of Chemical Formula B where anthracene is incorporated inside the biphenyl of said DPVBi has improved thermal stability by raising the glass transition temperature to 105°C The color purity and electroluminescent efficiency as a blue electroluminescent material, however, were not in a quite satisfactory level.

In the meanwhile, blue electroluminescence, when the electroluminescent wavelength is shifted from the present state to a longer wavelength, becomes advantageous in terms of electroluminescent efficiency, but it does not fulfill pure blue color so that it involves difficulties to be applied to a full-colored organic electroluminescent display requiring an electroluminescent material of pure blue color.

Thus, development of novel blue electroluminescent material is an urgent subject in order to develop a blue electroluminescent device or a full-colored electroluminescent device, because conventional blue electroluminescent compounds have lower electroluminescent efficiency than that of other colors.

International patent application WO 2004/020372 A discloses fluorene compounds and an organic luminescent device using the same, which fluorene compounds are represented by the following general formula [I]:

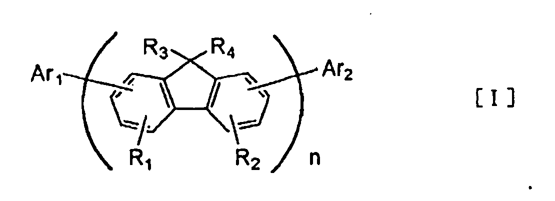

US patent application publication US 2002/132134 A1 relates to an electroluminescent device containing an anode, an organic electroluminescent element, and a cathode wherein the electroluminescent element contains, for example, a fluorescent hydrocarbon component of Formula (I) 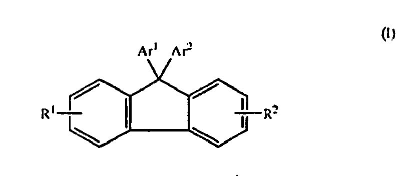 wherein R¹ and R² are substituents, which are selected from the group consisting of hydrogen, an alkyl, an alicyclic alkyl, an alkoxy, a halogen, and a cyano; Ar¹ and Ar² are each independently an aromatic component or an aryl group comprised of from about 4 to about 15 conjugate-bonded or fused benzene rings.

### [ Disclosure ]

### [ Technical Problem ]

The present invention noticeably improves the properties of a host which serves as a solvent or an energy carrier in electroluminescent materials as compared to the conventional materials. The object of the invention is to provide organic electroluminescent compounds having excellent electroluminescent efficiency and very good operative life. Another object of the invention is to provide an organic electroluminescent device containing the novel organic electroluminescent compound.

### [ Technical Solution ]

The present invention relates to a novel organic electroluminescent compound represented by the following chemical formula, i.e. Chemical Formula 1 as shown in claim 1: 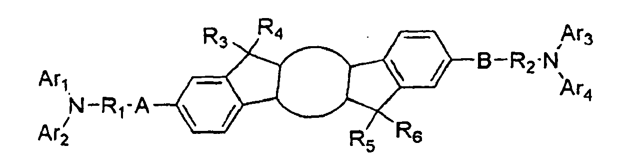 wherein, 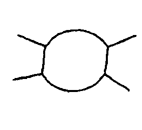 represents 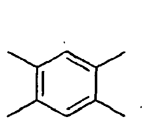 A and B independently represent a chemical bond, 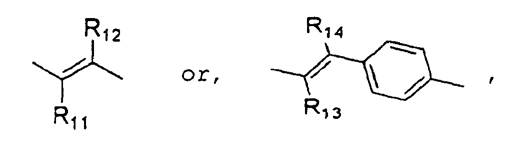
R₁ and R₂ independently represent an aromatic ring or a fused multi-cyclic aromatic ring having two or more aromatic rings,
R₃ through R₆ independently represent a linear or branched C₁-C₂₀ alkyl group with or without halogen substituent(s), a C₅-C₈ cycloalkyl group, or an aromatic group with or without halogen substituent(s),
R₁₁ through R₁₄ independently represent a hydrogen, a C₁-C₈ alkyl group, a C₅-C₈ cycloalkyl group or an aromatic group with or without halogen substituent(s),
Ar₁ through Ar₄ independently represent an aromatic ring or a fused multi-cyclic aromatic ring having two or more aromatic rings: and a display device employing the same as an electroluminescent material.

In the Chemcal Formulas of the present invention, it is referred to as "chemical bond" when there is no element in A or B but R₁ or R₂ is simply connected.

The organic electroluminescent compounds according to the present invention are advantageous in that they can be easily prepared in a high yield with high electroluminescent properties.

The compounds of Chemical Formula 1 according to the present invention include the compounds represented by Chemical Formulas 2, 3 and 5. Compounds of Chemical Formulas 4 and 6 are not within the scope of Chemical Formula 1. Compounds of Chemical Formulas 4 and 6 are mentioned only for comparison and/or reference.

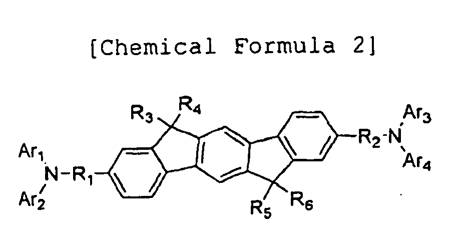

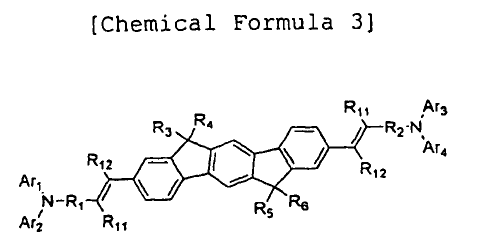

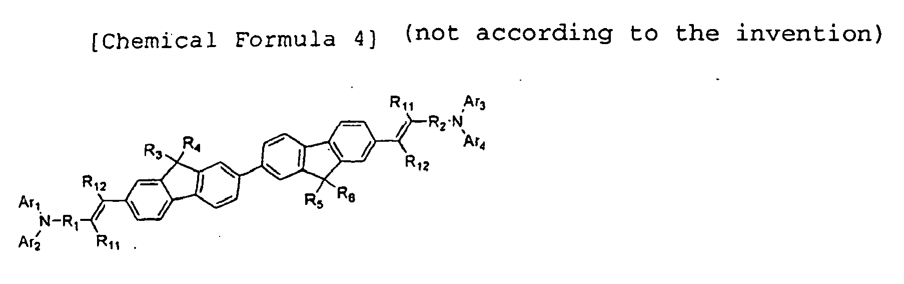

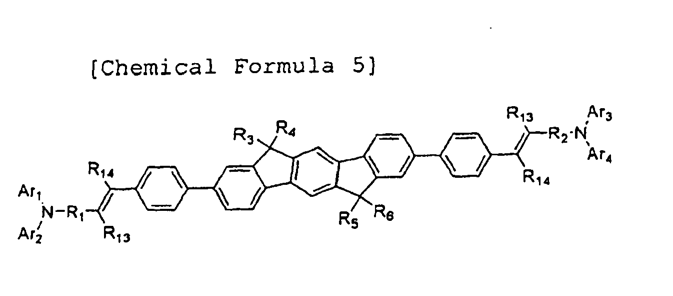

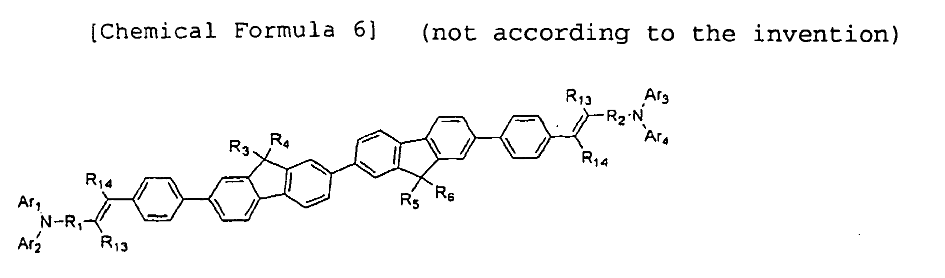

In the compounds represented by Chemical Formula 2 through Chemical Formula 6, R₁ and R₂ independently represent an aromatic group or a fused multi-cyclic aromatic ring having two or more aromatic rings, R₃ through R₆ independently represent a linear or branched C₁-C₂₀ alkyl group with or without halogen substituent(s), a C₅-C₈ cycloalkyl group, or an aromatic group with or without halogen substituent(s), R₁₁ through R₁₄ independently represent a hydrogen, a C₁-C₈ alkyl group, a C₅-C₈ cycloalkyl group or an aromatic group with or without halogen substituent(s), and Ar₁ through Ar₄ independently represent an aromatic ring or a fused multi-cyclic aromatic ring having two or more aromatic rings.

Specific examples of R₁ and R₂ in Chemical Formulas 2 through 6 include phenylene, naphthalene, anthracene, naphthacene, pyrene, fluorene and biphenyl, R₃ through R₆ are methyl, ethyl, n-propyl, i-propyl, n-butyl, i-butyl, t-butyl, n-pentyl, i-amyl, n-hexyl, n-heptyl, n-octyl, 2-ethylhexyl, n-nonyl, trifluoromethyl, pentafluoroethyl, cyclopentyl, cyclohexyl, cycloheptyl, cyclooctyl, phenyl, tolyl, 1-naphthyl, 2-naphthyl, 2-fluorophenyl or 4-fluorophenyl, R₁₁ through R₁₄ are hydrogen, methyl, ethyl, n-propyl, i-propyl, n-butyl, i-butyl, t-butyl, n-pentyl, n-hexyl, n-heptyl, n-octyl, cyclopentyl, cyclohexyl, cycloheptyl, cyclooctyl, phenyl, tolyl, 1-naphthyl, 2-naphthyl, 2-fluorophenyl or 4-fluorophenyl, and Ar₁ through Ar₄ are phenyl, tolyl, xylyl, pyridyl, biphenyl, naphthyl, anthryl, phenanthryl, naphthacenyl, acenaphthenyl, pyrenyl, fluorenyl or perylenyl.

The organic electroluminescent compounds according to each one of Chemical Formulas 2, 3 and 5 can be specifically exemplified as the compounds having the structures as follows: 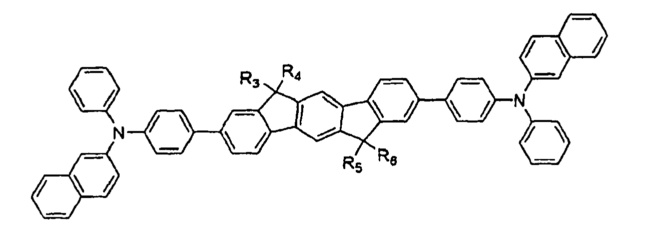 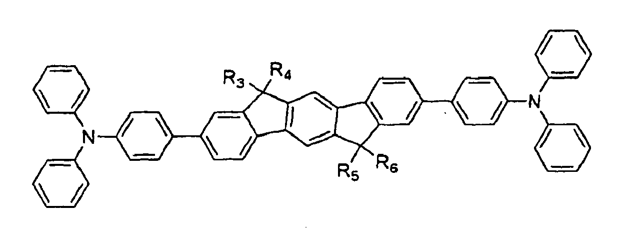 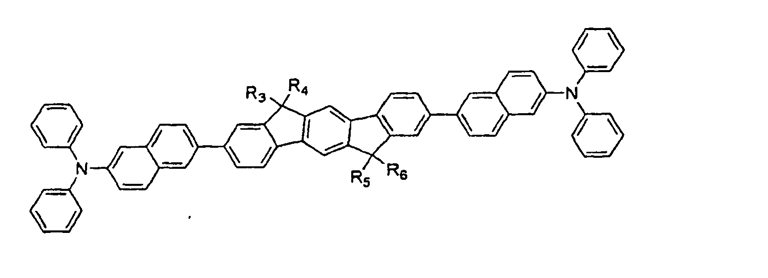 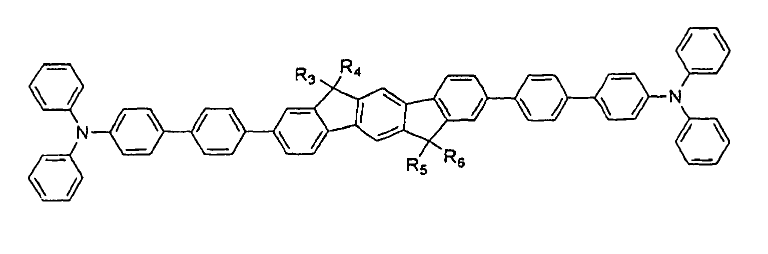 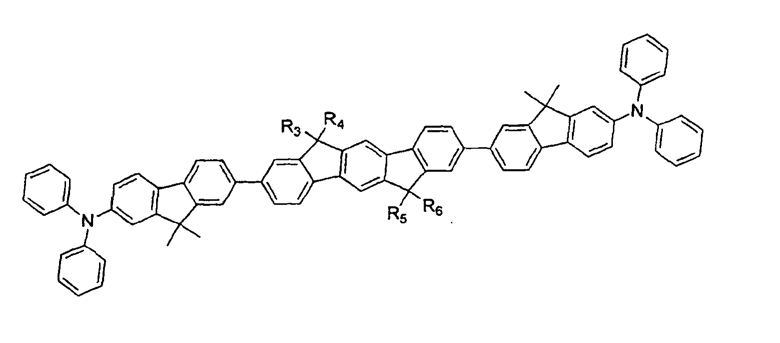 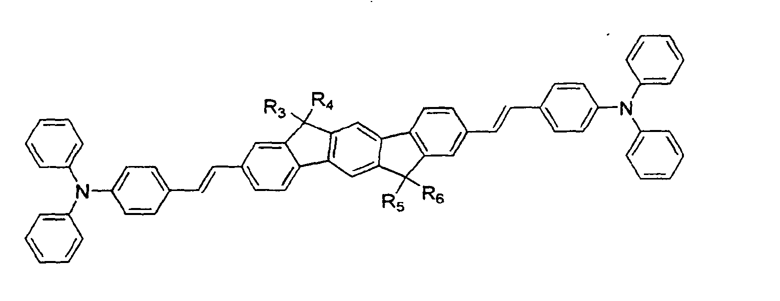 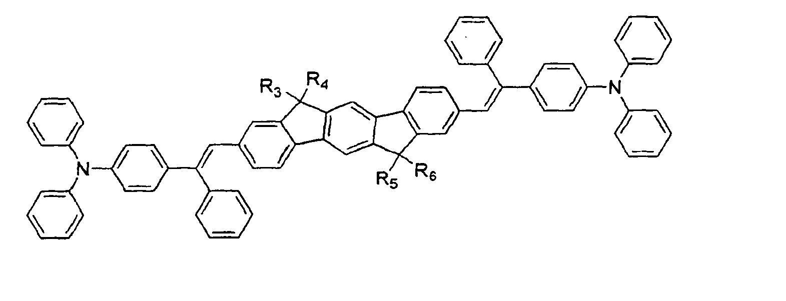 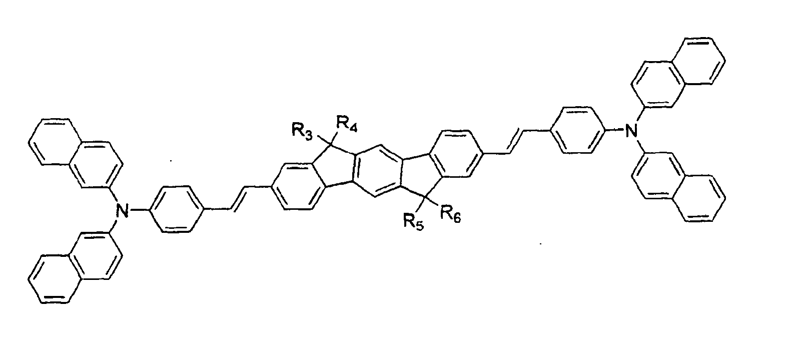 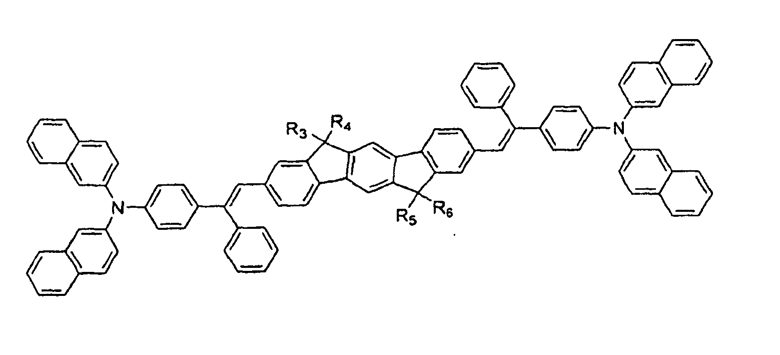 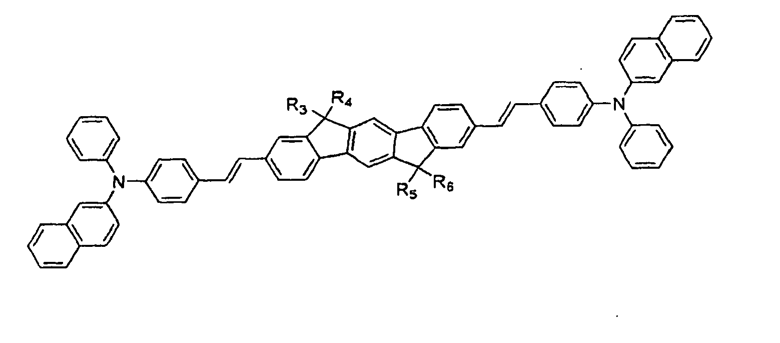 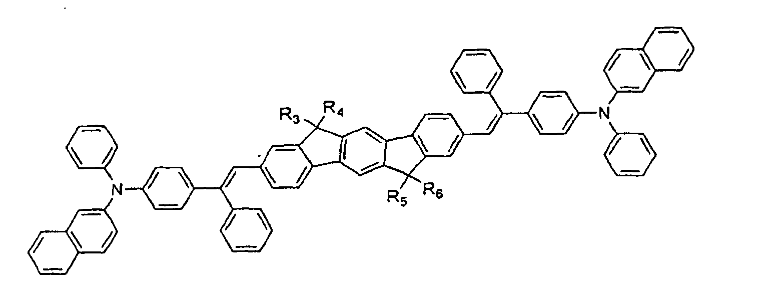 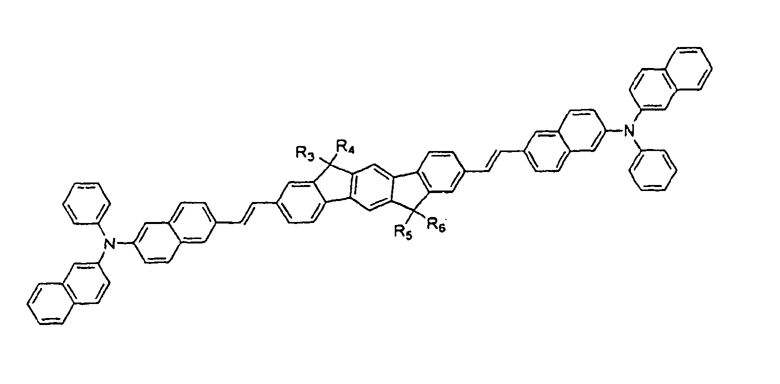 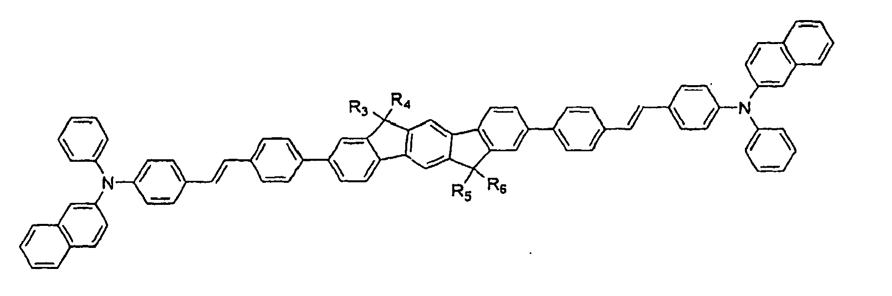 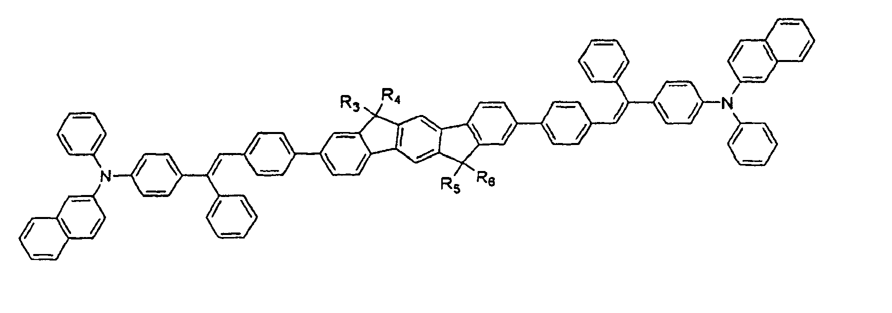 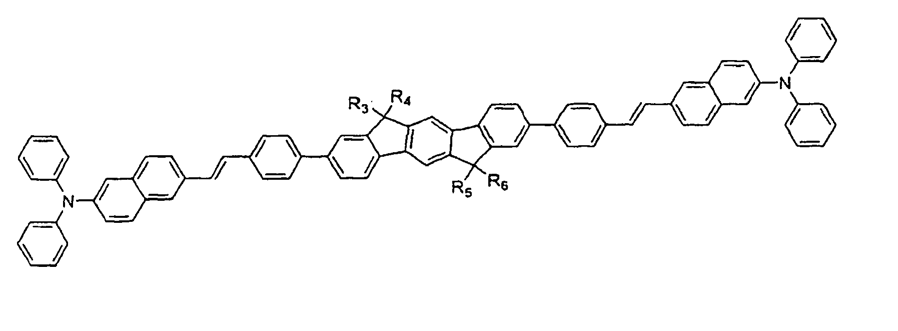 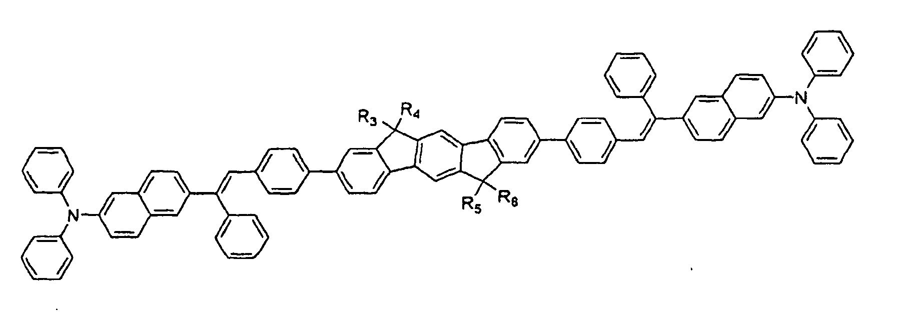 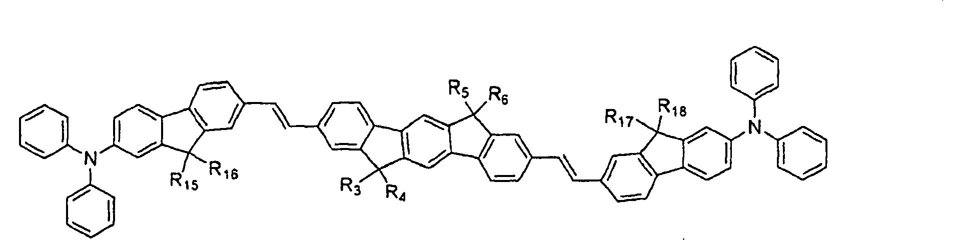 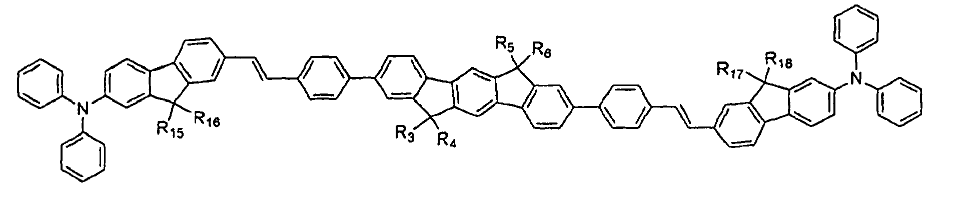 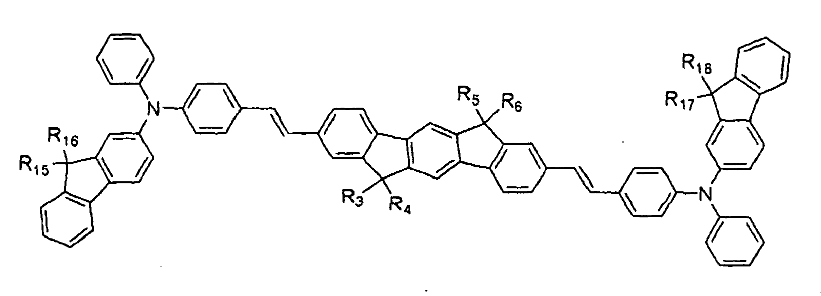 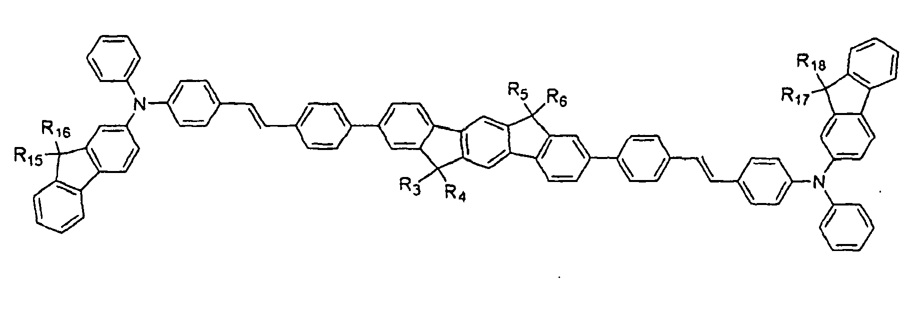 wherein, R₃ through R₆ represent methyl group or ethyl group, and R₁₅ to R₁₈ represent methyl group, ethyl group or phenyl group.

Each compound represented by Chemical Formulas 2, 3 or 5, as an organic electroluminescent compound can be prepared via a reaction route represented by Reaction Scheme 1, a compound of Chemical Formula 4 via a reaction route of Reaction Scheme 2, and a compound of Chemical Formula 6 via that of Reaction Scheme 3.

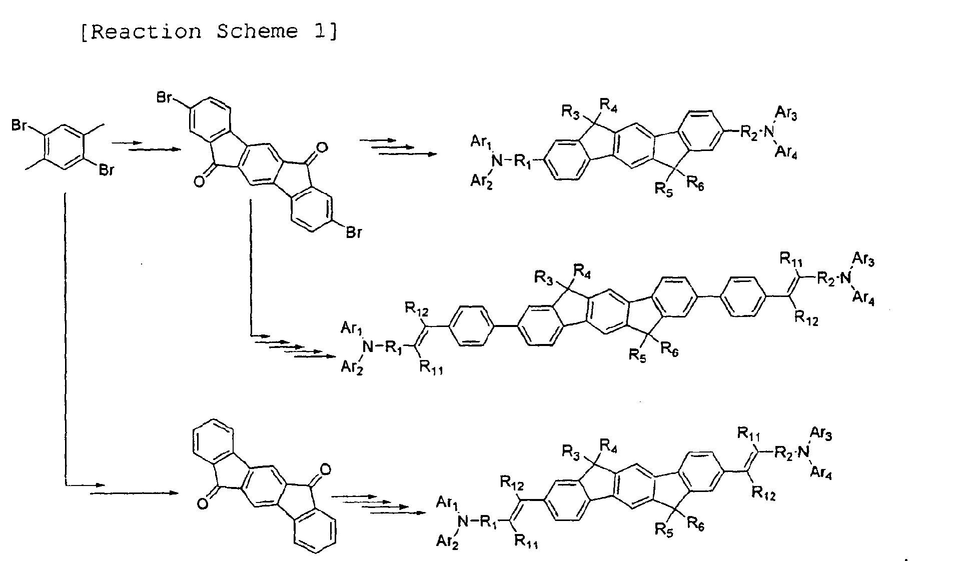

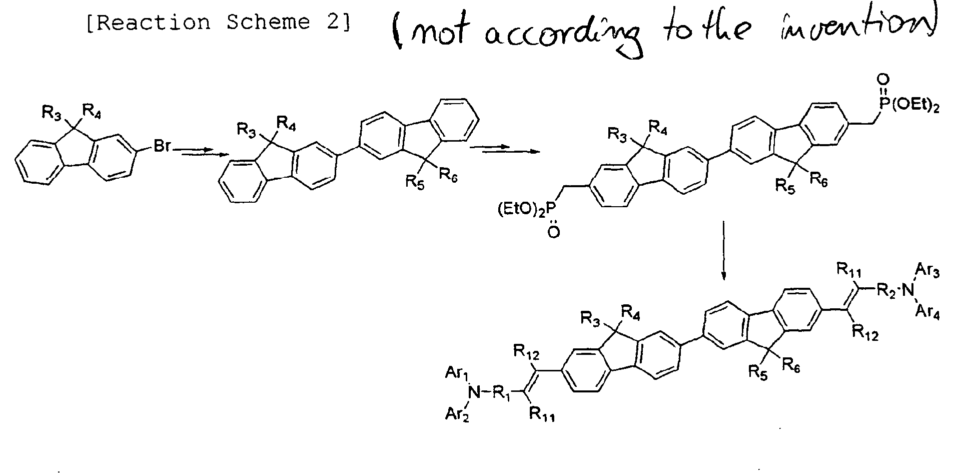

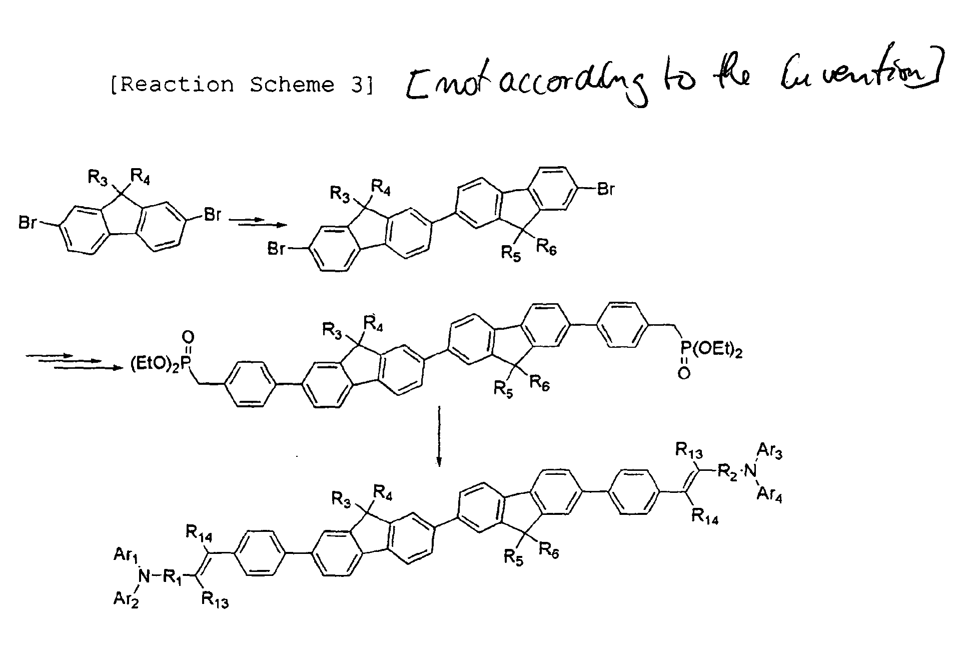

### [ Brief Description of Drawings]

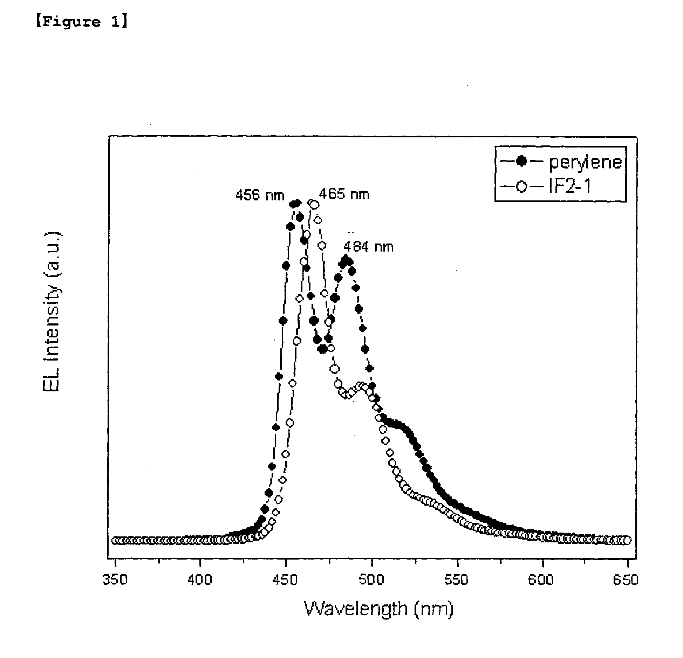

Fig. 1 is a graph showing the EL spectrum of an OLED employing IF2-1 as an electroluminescent material of the present invention and that of Comparative Example 1,

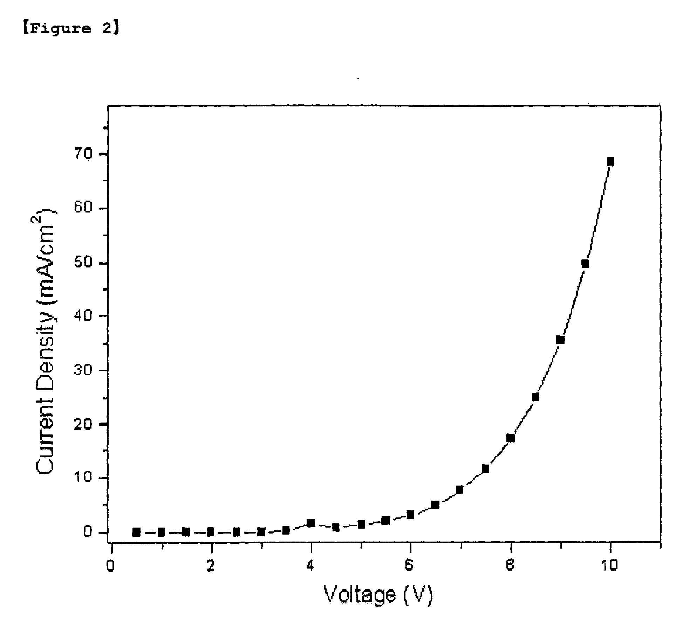

Fig. 2 is a graph showing the change of current density with respect to voltage of an OLED employing IF2-1 as an electroluminescent material of the present invention,

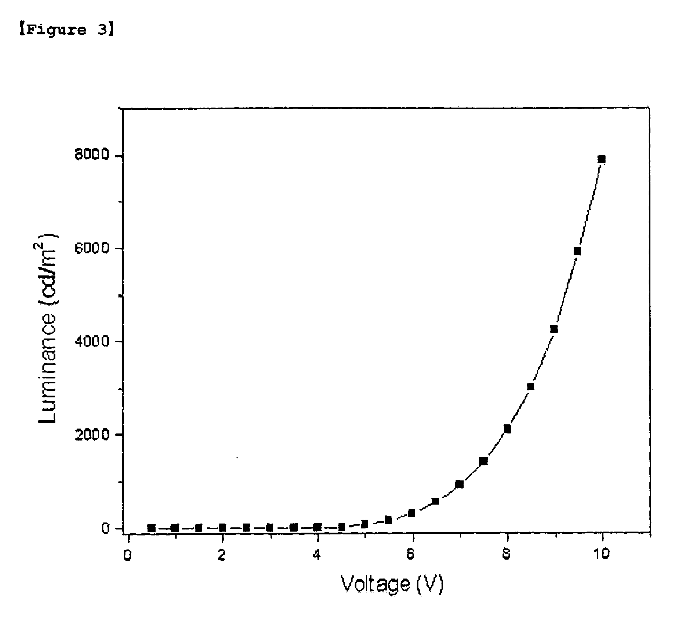

Fig. 3 is a graph showing the change of luminance with respect to the operating voltage of an OLED employing IF2-1 as an electroluminescent material of the present invention, and

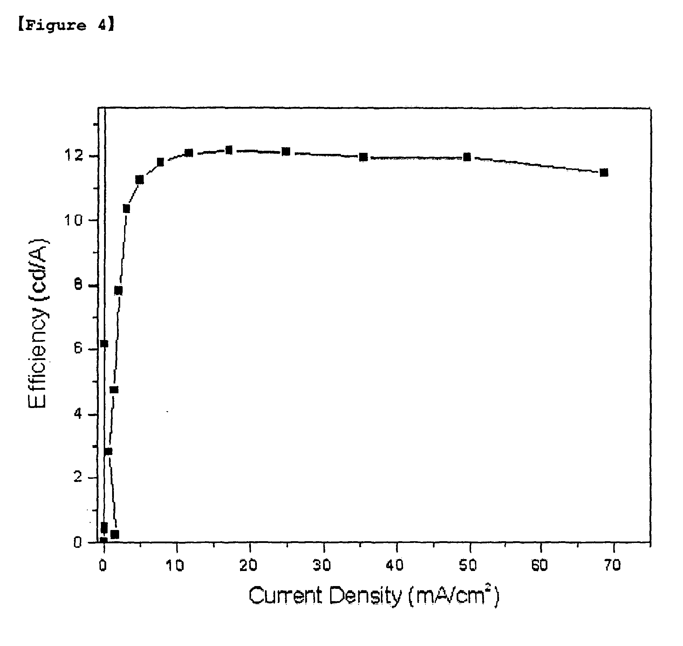

Fig. 4 is a graph showing the change of electroluminescent efficiency with respect to current density of an OLED employing IF2-1 element as an electroluminescent material of the present invention.

Other and further objects, features and advantages of the invention will appear more fully from the following description.

### Examples

The present invention is further described with respect to the electroluminescent compounds according to the invention, a process for preparing the same and the electroluminescent properties of the device employing the same by referring to representative compounds according to the present invention, which are provided for illustration only and are not intended to be limiting in any way.

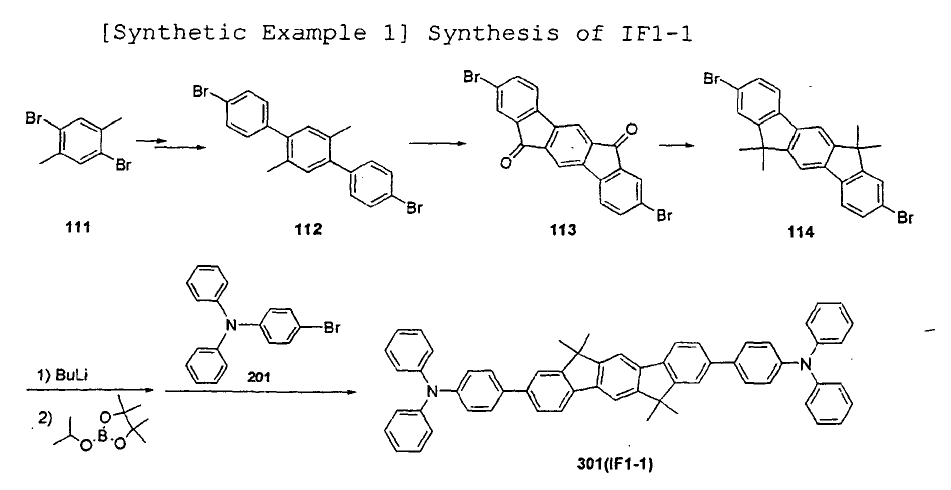

In 50 ml of THF, 2,5-dibromoxylene (2.0 g, 7.60 mmol) as Compound (111) was dissolved and tert-butyl lithium (1.5 equivalent) was added to the THF solution of 2,5-dibromoxylene (50 ml) at -80°C and the resultant solution was stirred at - 40°C under nitrogen atmosphere for 12 hours. After the stirring completed, 2-isopropoxy-4,4,5,5-tetramethyl-1,3,2-dioxaborolane (4.3 g, 23.1 mmol) was added thereto, while maintaining the temperature of the reaction mixture at -80°Cto provide a boronic ester compound of Compound (111) (2.31 g, 6.42 mmol), and the resultant boronic ester compound of Compound (111) (2.3 g) was dissolved in 50 ml of THF. To the solution, added were 1-bromo-4-iodobenzene (3.80 g, 13.4 mmol), Pd(PPh₃)₄ (1.5 g, 1.29 mmol) and aqueous 2M solution of calcium carbonate (20 ml), and the resultant mixture was heated under reflux for 10 hours. From the precipitate thus formed, Compound (112) (2.14 g, 5.14 mmol) was obtained.

Compound (112) (2.14 g) was dissolved in 20 ml of pyridine, and an aqueous 2M potassium permanganate solution (15 ml) was added thereto to provide a carboxylic acid at the end of Compound (112). The solid obtained from extraction of the organic layer was put into sulfuric acid, and the mixture was heated at 80°C for 12 hours. After lowering the temperature of said sulfuric acid solution to ambient temperature, the solution was poured into crushed ice. The solid thus formed was extracted to obtain Compound (113) (1.70 g, 3.86 mmol).

Compound (113) (1.70 g) was put into diethylene glycol (30 ml), and hydrazine hydrate (0.58 g, 11.6 mmol) and potassium hydroxide (0.5 g) were added thereto, and the resultant mixture was heated under reflux for 48 hours. After completion of heating under reflux, the reaction mixture was cooled to ambient temperature and extracted from ethyl acetate to provide indinofluorene compound. After drying, the compound was dissolved in 30 ml of THF, and under nitrogen atmosphere, methyl iodide (2.20 g, 15.5 mmol) was added thereto at -78°C and then 1.8 M solution of n-butyllithium in THF (15 ml) was slowly added thereto. After stirring the mixture for 1 hour, the temperature was raised to ambient temperature, and the mixture was again stirred and the reaction quenched by slowly adding 50 ml of water. After completion of the reaction, the reaction mixture was extracted from the organic layer and completely dried to obtain Compound (114) (1.17 g, 2.50 mmol).

Compound (114) (1.17 g) was dissolved in THF (30 ml), and 1.5 equivalent of tert-butyl lithium was added thereto. By the use of 2-isopropoxy-4,4,5,5-tetramethyl-1,3,2-dioxaborolane (1.4 g, 7.53 mmol), a boronic ester compound (1.33 g, 2.37 mmol) as Compound (114) was prepared. The boronic ester compound of Compound (114) (1.33 g) thus obtained was dissolved in 30 ml of THF solution, and Compound (201) (1.56 g, 4.81 mmol) and Pd(PPh₃)₄ (0.56 g, 0.48 mmol) and aqueous 2M solution of calcium carbonate (10 ml) were added thereto. After heating the reaction mixture under reflux for 12 hour, the precipitate thus formed was extracted with ethyl acetate. After recrystallization and drying, Compound (301, IF1-1) (1.50 g, 1.88 mmol) was obtained as the title compound in total yield of 24.7%.
¹H NMR(200MHz, CDCl₃): δ 1.65(s, 12H), 6.45-6.55(m, 12H), 6.6-6.65(m, 4H), 7.0-7.05(m, 8H), 7.2-7.25(d, 4H), 7.65(d, 2H), 7.73(d, 2H), 7.80(s, 2H), 8.0-8.1(d, 2H)
MS/FAB: 796(found), 797.06(calculated)

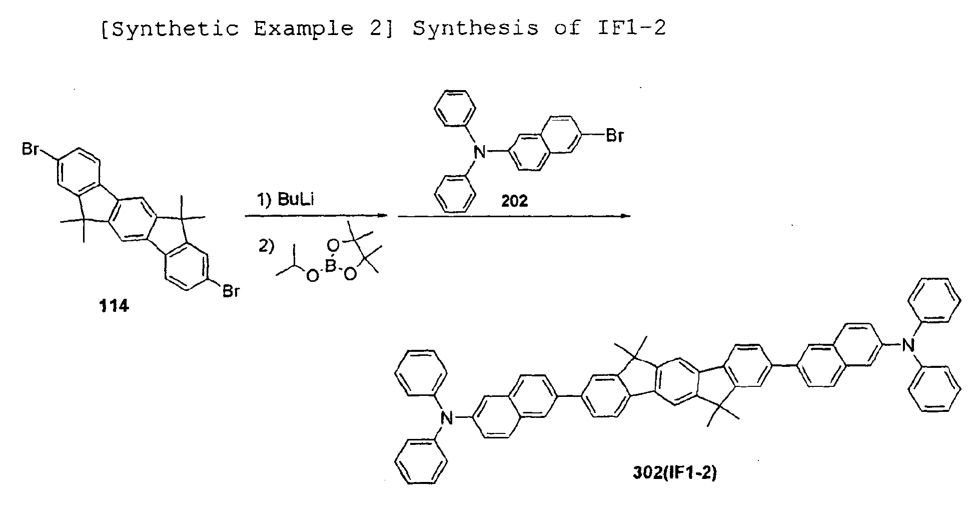

Compound (302, IF1-2) (1.16 g, 1.30 mmol) as the title compound was obtained in total yield of 19.0% according to the same procedure as Synthetic Example 1, but Compound 114 (1.0 g, 2.14 mmol), and Compound 202 (1.61 g, 4.30 mmol) instead of Compound 201 were employed.
¹H NMR(200MHz, CDCl₃ ): δ 1.65(s, 12H), 6.45-6.5(m, 8H), 6.6-6.65(m, 4H), 6.75-6.8(m, 4H), 7.0-7.05(m, 8H), 7.45 - 7.55(m, 6H), 7.65(d, 2H), 7.75-7.85(m, 6H), 8.0-8.05(d, 2H)
MS/FAB: 896 (found), 897.19(calculated)

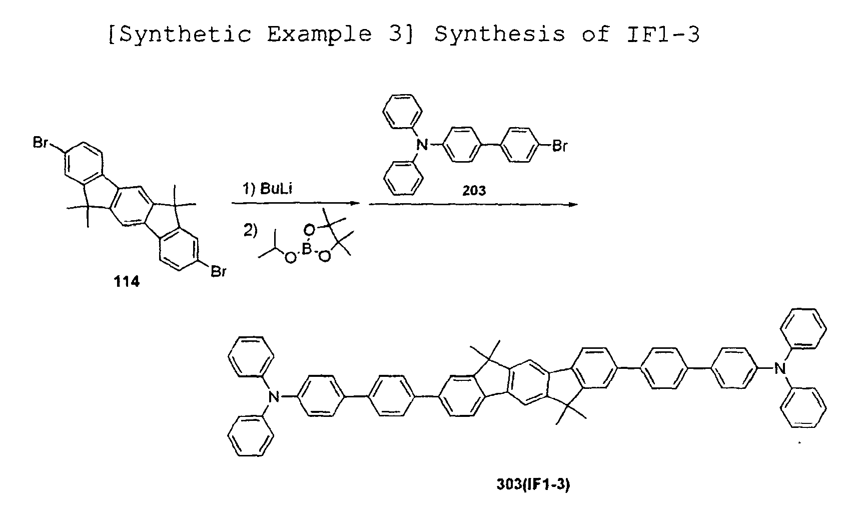

Compound (303, IF1-3) (1.12 g, 1.18 mmol) as the title compound was obtained in total yield of 17.2% according to the same procedure as Synthetic Example 1, but Compound 114 (1.0 g, 2.14 mmol), and Compound 203 (1.72 g, 4.30 mmol) instead of Compound 201 were employed.
¹H NMR(200MHz, CDCl₃): δ 1.65 (s, 12H), 6.45-6.55(m, 12H), 6.6-6.65(m, 4H), 7.0-7.05 (m, 8H), 7.2-7.25(d, 4H), 7.55-7.57(d, 8H), 7.65(d, 2H), 7.75 (s, 2H), 7.8 (s, 2H), 8.0-8.05(d, 2H) MS/FAB: 948 (found), 949.26(calculated)

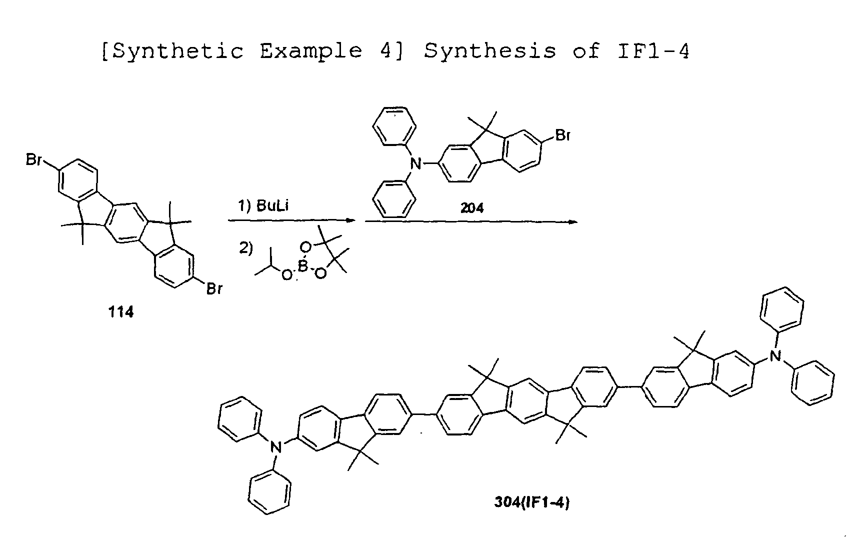

Compound (304, IF1-4) (0.95 g, 0.92 mmol) as the title compound was obtained in total yield of 13.4% according to the same procedure as Synthetic Example 1, but Compound 114 (1.0 g, 2.14 mmol), and Compound 204 (1.90 g, 4.32 mmol) instead of Compound 201 were employed.
¹H NMR (200MHz, CDCl₃): δ 1.63-1.65(d, 24H), 6.45-6.50(d, 8H), 6.55-6.65(m, 6H), 6.75(s, 2H), 7.0-7.05(m, 8H), 7.58-7.65(m, 6H), 7.73-7.85(m, 6H), 8.0-8.05(d, 2H)
MS/FAB: 1028(found), 1029.39(calculated)

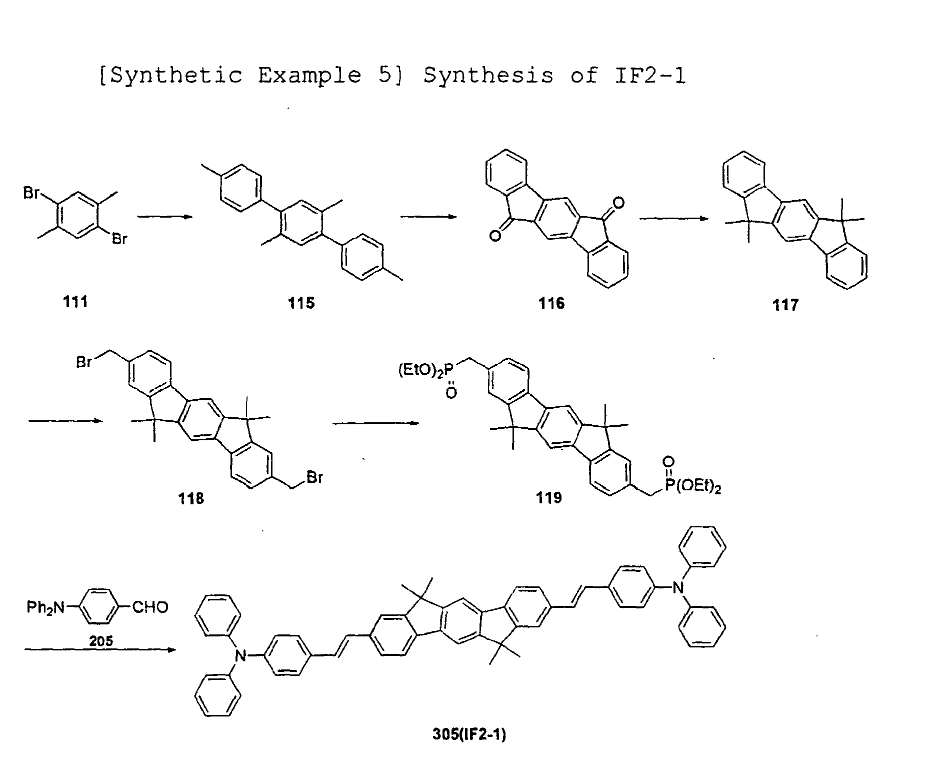

In 50 ml of THF, 2,5-dibromoxylene (2.0 g, 7.60 mmol) was dissolved, and phenyl boronic acid (1.95 g, 16.0 mmol) and Pd (PPh₃)₄ (1.95 g, 1.68 mmol), aqueous 2M calcium carbonate solution (25 ml) were added to the THF solution of 2,5-dibromoxylene (50 ml), and the resultant mixture was heated under reflux for 10 hours. From the precipitate thus formed, Compound (115) (1.86 g, 7.2 mmol) was obtained.

Compound (115) (1.86 g) was dissolved in 20 ml of pyridine, and an aqueous 2M potassium permanganate solution (15 ml) was added thereto to provide carboxylic acid at the end of the compound. The solid obtained from extraction of the organic layer was put into sulfuric acid, and the mixture was heated at 80°C for 12 hours. After lowering the temperature of said sulfuric acid solution to ambient temperature, the solution was poured into crushed ice. The solid thus formed was extracted to obtain Compound (116) (1.64 g, 5.82 mmol).

Compound (116) (1.64 g) was put into diethylene glycol (30 ml), and hydrazine hydrate (0.85 g, 17.0 mmol) and potassium hydroxide (0.8 g) were added thereto, and the resultant mixture was heated under reflux for 48 hours. After completion of heating under reflux, the reaction mixture was cooled to ambient temperature and extracted from ethyl acetate to provide indinofluorene compound. After drying, the compound was dissolved in 30 ml of THF, and under nitrogen atmosphere, methyl iodide (1.65 g, 11.6 mmol) was added thereto at -78°C and then 1.8 M solution of n-butyllithium in THF (12 ml) was slowly added thereto. After stirring the mixture for 1 hour, the temperature was raised to ambient temperature, and the mixture was again stirred for 24 hours and the reaction was quenched by slowly adding 50 ml of water. After completion of the reaction, the reaction mixture was extracted from organic layer and completely dried to obtain Compound (117) (1.25 g, 4.03 mmol) .

Compound (117) (1.25 g, 4.03 mmol) and paraformaldehyde (1.8 g) were added to 35% HBr solution in acetic acid (15 ml), and the mixture was heated at 60°C for 24 hours. The temperature of the reaction mixture was then lowered to ambient temperature, extracted and dried to obtain Compound (118) (1.34 g, 2.70 mmol), which was charged in a reaction vessel. Triethylphosphite (2.0 g, 12.0 mmol) was added thereto at 0°C and the mixture was heated at 150°Cfor 4 hours. After completion of the reaction, residual triethylphosphite was removed by vacuum distillation, and the residue was extracted from ethyl acetate to obtain Compound (119) (1.4 g, 2.30 mmol). Compound (119) (1.4 g) and Compound (205) (1.30 g, 4.76 mmol) were dissolved in THF (30 ml), and 1.6 M solution of potassium tert-butoxide in THF (5 ml) was added dropwise to the mixed solution. The temperature was slowly raised to ambient temperature to complete the reaction. Then an excess amount of water was poured thereto to generate solid, which was then filtered. After recrystallization from THF-methanol, Compound (305, IF2-1) (1.23 g, 1.45 mmol) was obtained as the title compound in total yield of 19.1%.
¹H NMR(200MHz, CDCl₃ ): δ 1.65(s, 12H), 6.45-6.5(m, 12H), 6.6-6.65(m, 4H), 6.95-7.05(m, 12H), 7.15-7.2(d, 4H), 7.57-7.6(d, 2H), 7.7-7.75(d, 4H), 7.9-8.0(d, 2H)
MS/FAB: 848(found), 849.14(calculated)

### [Synthetic Example 6] Synthesis of IF2-2

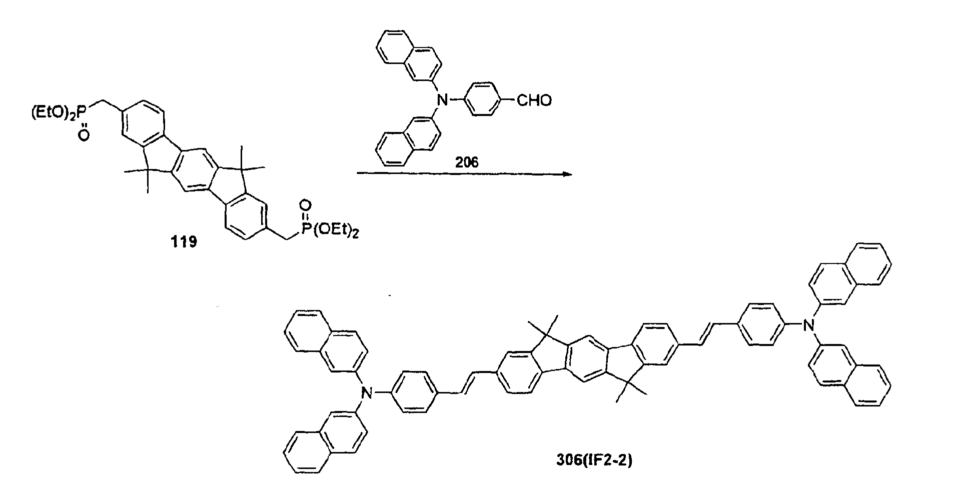

Compound (306, IF2-2) (0.95 g, 0.91 mmol) as the title compound was obtained in total yield of 16.8% according to the same procedure as Synthetic Example 5, but Compound 119 (1.0 g, 1.64 mmol), and Compound 206 (1.28 g, 3.43 mmol) instead of Compound 205 were employed.
¹H NMR(200MHz, CDCl₃): δ 1.65(s, 12H), 6.45-6.50(d, 4H), 6.75-6.8(m, 8H), 7.0(d, 4H), 7.15-7.3(m, 12H), 7.4-7.6(m, 14H), 7.7-7.75(d, 4H), 7.9-8.0(d, 2H)
MS/FAB: 1048(found), 1049.38(calculated)

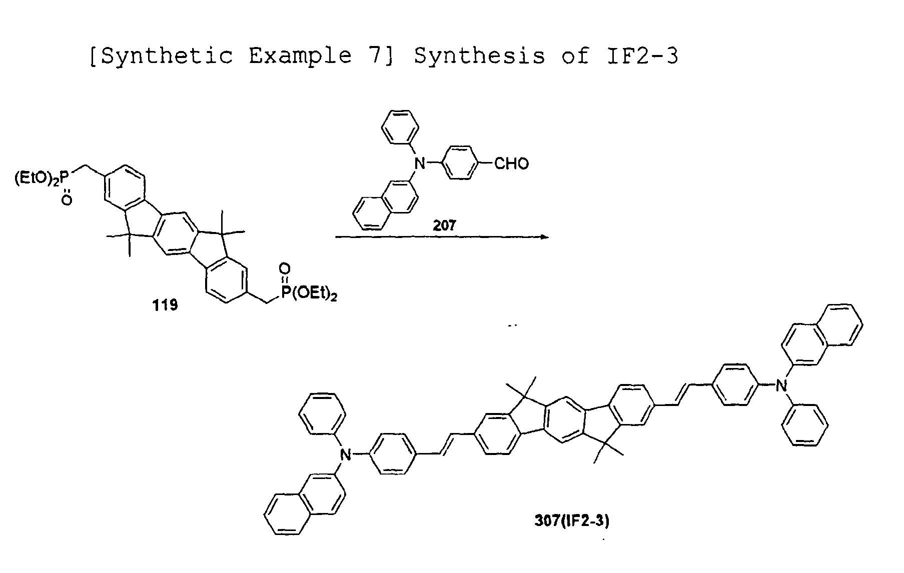

Compound (307, IF2-3) (0.92 g, 1.08 mmol) as the title compound was obtained in total yield of 20.0% according to the same procedure as Synthetic Example 5, but Compound 119 (1.0 g, 1.64 mmol), and Compound 207 (1.10 g, 3.41 mmol) instead of Compound 205 were employed.
¹H NMR (200MHz, CDCl₃) : δ 1. 65 (s, 12H), 6.45-6.5 (d, 8H), 6.6-6.65(m, 2H), 6.75-6.8(m, 4H), 6.95-7.25(m, 16H), 7.4-7.6(m, 8H), 7.7-7.75(d, 4H), 7.9-8.0(d, 2H)
MS/FAB: 948 (found), 949.26(calculated)

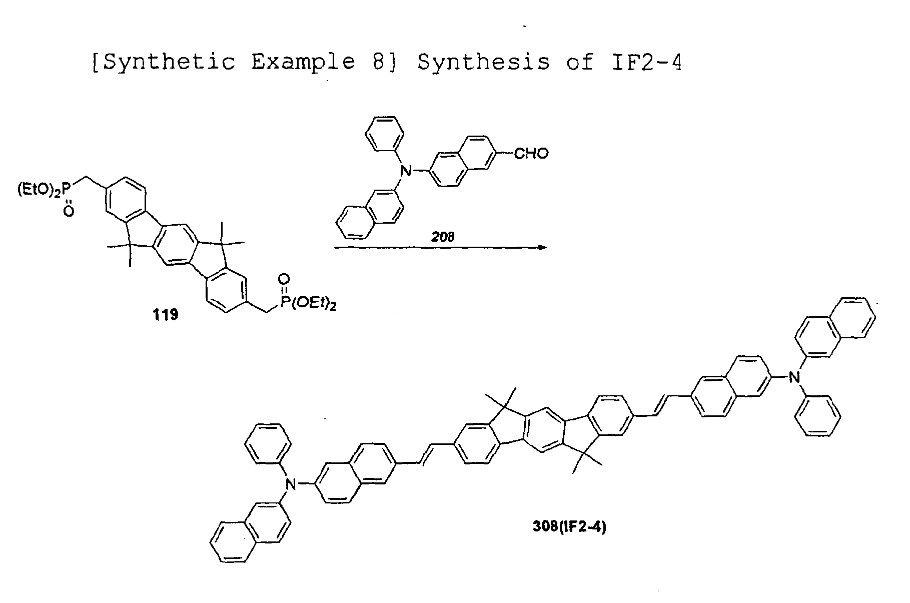

Compound (308, IF2-4) (0.71 g, 0.68 mmol) as the title compound was obtained in total yield of 12.6% according to the same procedure as Synthetic Example 5, but Compound 119 (1.0 g, 1.64 mmol), and Compound 208 (1.28 g, 3.43 mmol) instead of Compound 205 were employed.
¹H NMR(200MHz, CDCl₃): δ 1.65(s, 12H), 6.45-6.5(d, 4H), 6.6-6.65(m, 2H), 6.75-6.8(m, 8H), 6.95-7.1(m, 10H), 7.2-7.25(m, 2H), 7.35-7.6(m, 14H), 7.7-7.75 (d; 6H), 7.9-8.0(d, 2H)
MS/FAB: 1048(found), 1049.38(calculated)

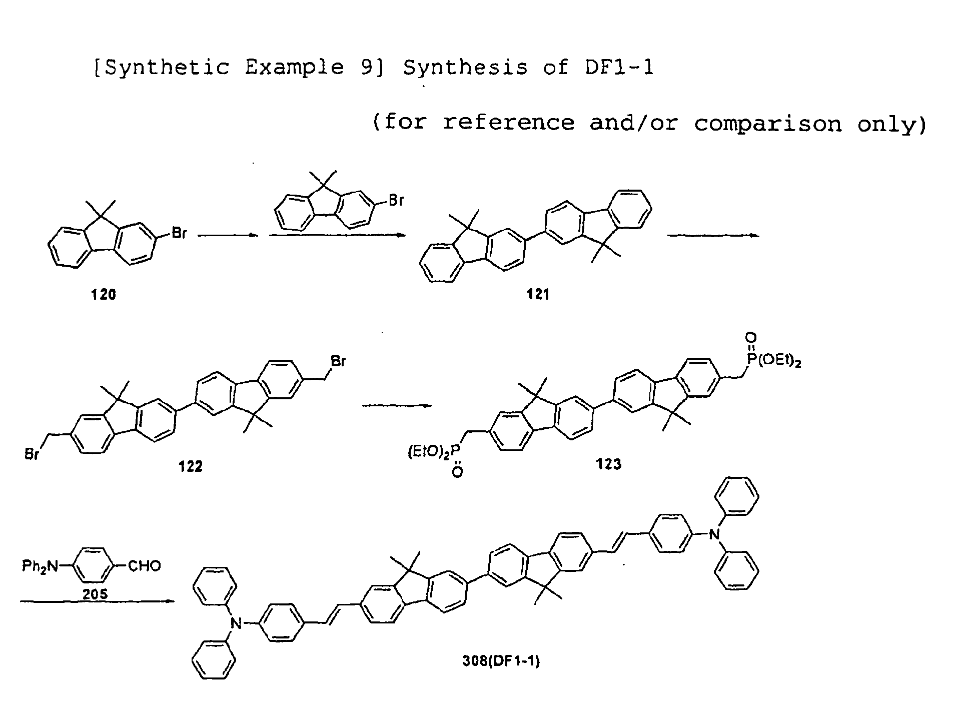

In 50 ml of THF, 2-bromo-9,9-dimethylfluorene (2.0 g, 7.33 mmol) as Compound (120) was dissolved and tert-butyl lithium (1.5 equivalent) was added to the THF solution of 2-bromo-9,9-dimethylfluorene (50 ml) at -80°C and the resultant solution was stirred at -40°C under nitrogen atmosphere for 12 hours.

After the stirring completed, 2-isopropoxy-4,4,5,5-tetramethyl-1,3,2-dioxaborolane (4.3 g, 23.1 mmol) was added thereto, while maintaining the temperature of the reaction mixture at -80°C to provide a boronic ester compound of Compound (120) (2.16 g, 6.75 mmol), and the resultant boronic ester compound of Compound (120) (2.16 g) was dissolved in 50 ml of THF. To the solution, 2-bromo-9,9-dimethylfluorene (1.92 g, 7.03 mmol), Pd(PPh₃)₄ (0.97 g, 0.84 mmol) and aqueous 2M solution of calcium carbonate (15 ml) were added and the resultant mixture was heated under reflux for 10 hours. From the precipitate thus formed, Compound (121) (2.26 g, 5.85 mmol) was obtained.

Compound (121) (2.26 g) and paraformaldehyde (2.6 g) were added to 35% HBr solution in acetic acid (20 ml), and the mixture was heated at 60°C for 24 hours. Then the temperature of the reaction mixture was lowered to ambient temperature, extracted and dried to obtain Compound (122) (2.64 g, 4.62 mmol). Compound (122) (2.64 g) was charged to a reaction vessel. Triethylphosphite (3.42 g, 20.6 mmol) was added thereto at 0°C and the mixture was heated at 150°C for 4 hours. After completion of the reaction, residual triethylphosphite was removed by vacuum distillation, and the residue was extracted from ethyl acetate to obtain Compound (123) (2.13 g, 3.10 mmol).

Compound (123) (2.13 g) and Compound (205) (1.86 g, 6.81 mmol) were dissolved in THF (40 ml), and 1.6 M solution of potassium tert-butoxide in THF (10 ml) was added dropwise to the mixed solution at 0°C The temperature was slowly raised to ambient temperature to complete the reaction. Then an excess amount of water was poured thereto to generate solid, which was then filtered. After recrystallization form THF-methanol, Compound (309, DFI-1) (1.54 g, 1.67 mmol) was obtained as the title compound in total yield of 22.8%.
¹H NMR(200MHz, CDCl₃): δ 1.65(s, 12H), 6.45-6.5(m, 12H), 6.6-6.65(m, 4H), 6.95-7.05(m, 12H), 7.15-7.2(d, 4H), 7.5-7.65(m, 4H), 7.7-7.8(m, 4H), 7.85-7.9(d, 4H)
MS/FAB: 924(found), 925.24(calculated)

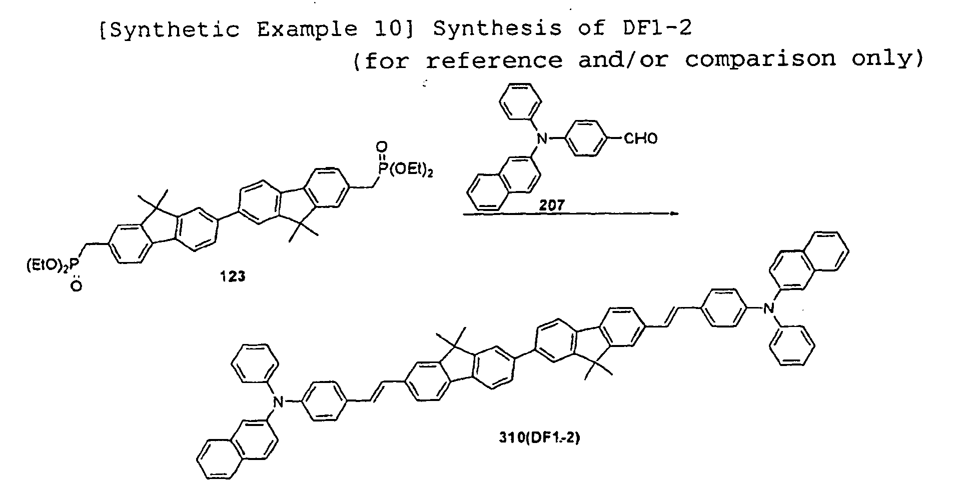

Compound (310, DF1-2) (0.88 g, 0.86 mmol) as the title compound was obtained in total yield of 24.9% according to the same procedure as Synthetic Example 9, but Compound 123 (1 g, 1.46 mmol), and Compound 207 (1.03 g, 3.19 mmol) instead of Compound 205 were employed.
¹H NMR(200MHz, CDCl₃): δ 1.65(s, 12H), 6.45-6.5(m, 8H), 6.6-6.65(m, 2H), 6.75-6.8(m, 4H), 6.95-7.25(m, 16H), 7.35-7.6(m, 10H), 7.7-7.8(d, 4H), 7.8-7.9(d, 4H)
MS/FAB: 1024(found), 1025.36(calculated)

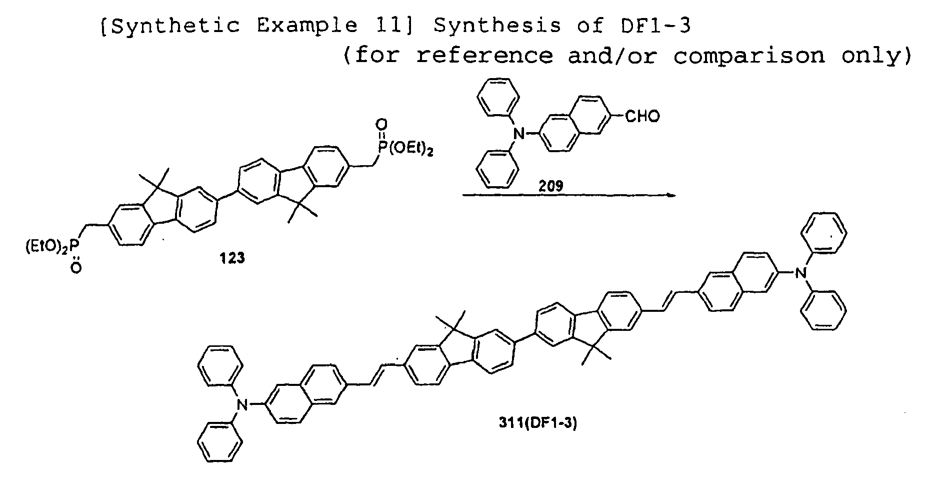

Compound (311, DF1-3) (0.56 g, 0.55 mmol) as the title compound was obtained in total yield of 15.9% according to the same procedure as Synthetic Example 9, but Compound 123 (1 g, 1.46 mmol), and Compound 209 (1.03 g, 3.19 mmol) instead of Compound 205 were employed.
¹H NMR (200MHz, CDCl₃) : δ 1.65(s, 12H), 6.45-6.5(m, 8H), 6.6-6.65(m, 4H), 6.75-6.8(m, 4H), 6.95-7.05(m, 12H), 7.35-7.6(m, 10H), 7.7-7.8(t, 6H), 7.8-7.9(d, 4H)
MS/FAB: 1024(found), 1025.36(calculated)

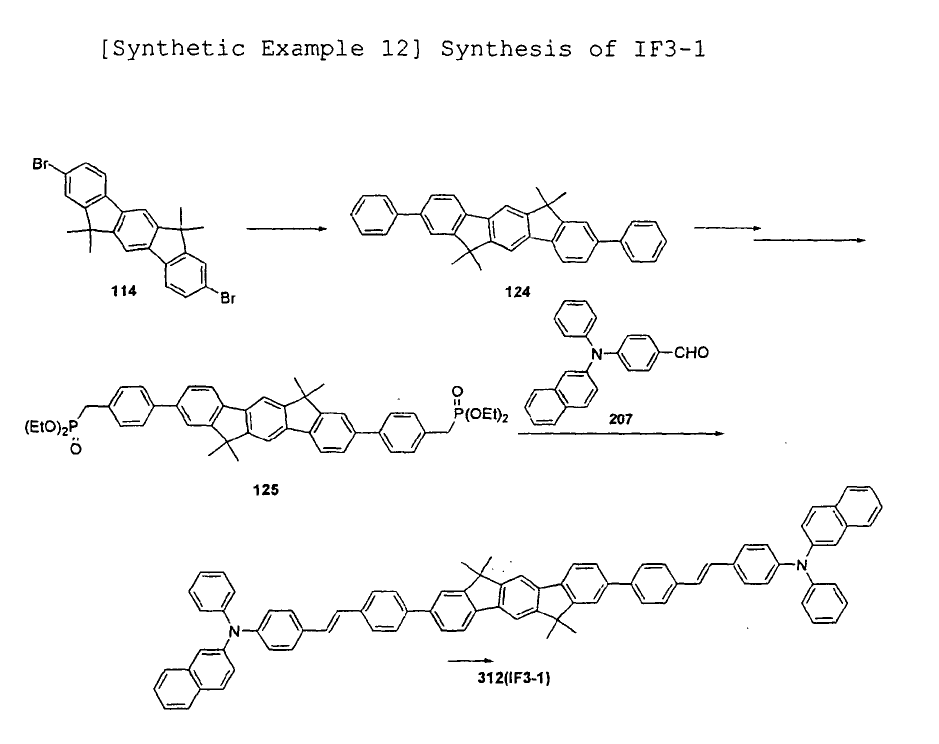

To a solution of Compound (114) (2.0 g, 4.27 mmol) in THF (50 ml), added were phenyl boronic acid (1.10 g, 9.02 mmol), Pd(PPh₃)₄ (1.04 g, 0.90 mmol), and aqueous 2M calcium carbonate solution (15 ml), and the resultant mixture was heated under reflux for 10 hours. From the precipitate thus formed, obtained was Compound (124) (1.80 g, 3.90 mmol).

Compound (124) (1.80 g) and paraformaldehyde (1.7 g) were added to 35% HBr solution in acetic acid (20 ml), and the mixture was heated at 60°C for 24 hours. Then the temperature of the reaction mixture was lowered to ambient temperature, extracted and dried to obtain a bromomethyl derivative, which was then charged to a reaction vessel. Triethylphosphite (2.57 g, 15.5 mmol) was added thereto at 0°C and the mixture was heated at 150°C for 4 hours. After completion of the reaction, residual triethylphosphite was removed by vacuum distillation, and the residue was extracted from ethyl acetate to obtain Compound (125) (1.66 g, 2.18 mmol-) .

Compound (125) (1.66 g) and Compound (207) (1.48 g, 4.58 mmol) were dissolved in THF (50 ml), and 1.6 M solution of potassium tert-butoxide in THF (8 ml) was added dropwise to the mixed solution at 0°C The temperature was slowly raised to ambient temperature to complete the reaction. Then an excess amount of water was poured thereto to generate solid, which was then filtered. After recrystallization from ethanol, Compound (312, IF3-1) (1.65 g, 1.65 mmol) was obtained as the title compound in total yield of 38.6%.
¹H NMR(200MHz, CDCl₃): δ 1.65(s, 12H), 6.45-6.5(m, 8H), 6.6-6.65(m, 2H), 6.75-6.8(m, 4H), 6.95-7.3(m, 16H), 7.4-7.6(m, 14H), 7.65(d, 2H), 7.75(s, 2H), 7.8(s, 2H), 7.95-8.05(d, 2H) MS/FAB: 1100(found), 1101.46(calculated)

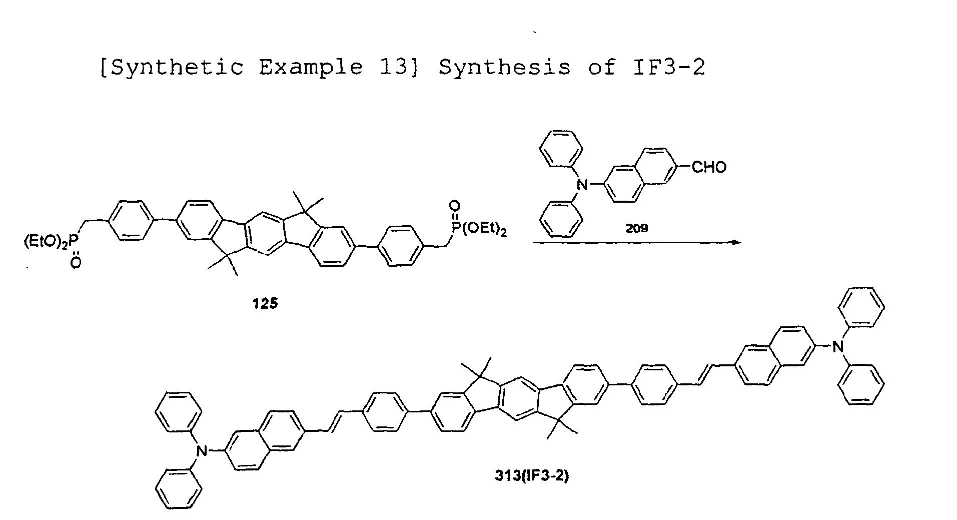

Compound (313, IF3-2) (0.86 g, 0.78 mmol) as the title compound was obtained in total yield of 30.4% according to the same procedure as Synthetic Example 12, but Compound 125 (1 g, 1.31 mmol), and Compound 209 (0.90 g, 2.79 mmol) instead of Compound 207 were employed.
¹H NMR(200MHz, CDCl₃): δ 1.65(s, 12H), 6.45-6.5(m, 8H), 6.6-6.65(m, 4H), 6.75-6.8(m, 4H), 6.95-7.05(m, 12H), 7.4-7.55(m, 14H), 7.65(d, 2H), 7.7-7.75(d, 4H), 7.8(s, 2H), 7.95-8.05(d, 2H)
MS/FAB: 1100(found), 1101.46(calculated)

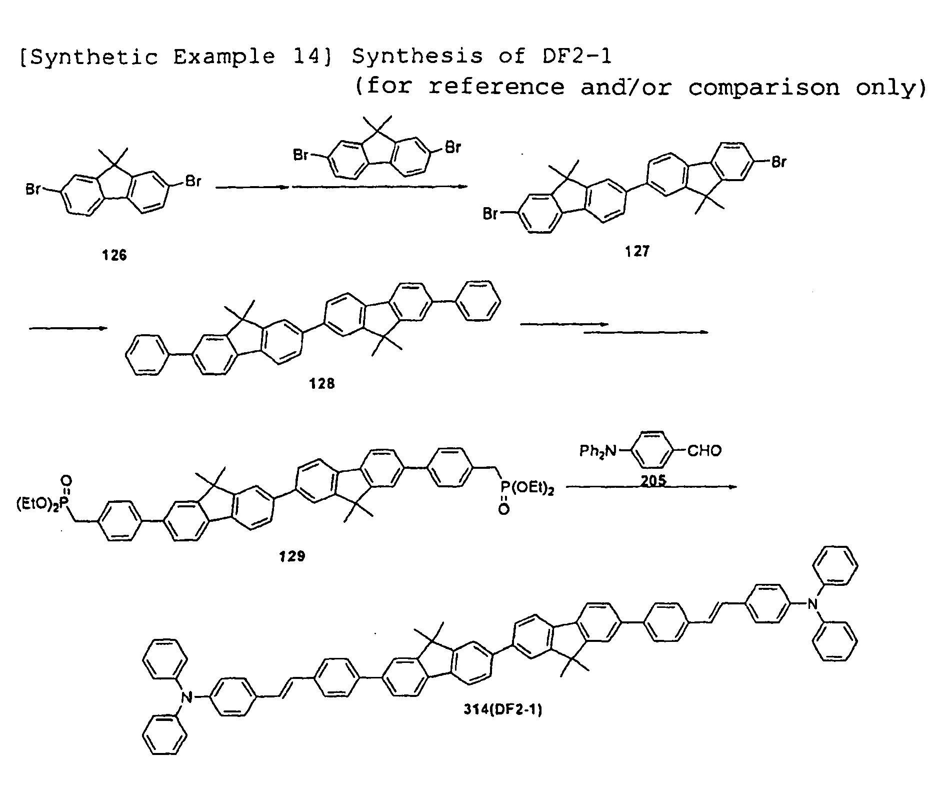

To a solution of 2,7-dibromo-9,9-dimethylfluorene (2.0 g, 5,68 mmol) as Compound (126) in THF (50 ml), added was 1.5 equivalent of tert-butyl lithium at -80°C and the resultant solution was stirred at -40°C under nitrogen atmosphere for 12 hours.

After the stirring completed, 2-isopropoxy-4,4,5,5-tetramethyl-1,3,2-dioxaborolane (0.95 g, 5.11 mmol) was added thereto, while maintaining the temperature of the reaction mixture at -80°C to provide a boronic ester compound of Compound (126) (1.86 g, 4.66 mmol), and the resultant boronic ester compound of Compound (126) (1.86 g) was dissolved in 50 ml of THF. To the solution, added were 2,7-dibromo-9,9-dimethylfluorene (1.56 g, 4.43 mmol), Pd(PPh₃)₄ (0.67 g, 0.58 mmol) and aqueous 2M solution of calcium carbonate (10 ml), and the resultant mixture was heated under reflux for 10 hours. From the precipitate thus formed, obtained was Compound (127) (2.12 g, 3.90 mmol).

To a solution of Compound (127) (2.12 g, 4.27 mmol) in THF (50 ml), added were phenyl boronic acid (1.00 g, 8.20 mmol), Pd(PPh₃)₄ (1.18 g, 1.02 mmol) and aqueous 2M calcium carbonate solution (20 ml), and the resultant mixture was heated under reflux for 10 hours. From the precipitate thus formed, obtained was Compound (128) (1.87 g, 3.48 mmol). Compound (128) (1.87 g) and paraformaldehyde (1.8 g) were added to 35% HBr solution in acetic acid (15 ml), and the mixture was heated at 60°C for 24 hours. Then the temperature of the reaction mixture was lowered to ambient temperature, extracted and dried to obtain a bromethyl derivative, which was then charged to a reaction vessel. Triethylphosphite (2.30 g, 13.9 mmol) was added dropwise thereto at 0°C and the mixture was heated at 150°C for 4 hours. After completion of the reaction, residual triethylphosphite was removed by vacuum distillation, and the residue was extracted from ethyl acetate to obtain Compound (129) (1.32 g, 1.57 mmol).

Compound (129) (1.32 g) and Compound (205) (0.90 g, 3.30 mmol) were dissolved in THF (30 ml), and 1.6 M solution of potassium tert-butoxide in THF (6 ml) was added to the mixed solution dropwise at 0°C The temperature was slowly raised to ambient temperature to complete the reaction. Then an excess amount of water was poured thereto to generate solid, which was then filtered. After recrystallization from ethanol, Compound (314, DF2-1) (1.28 g, 1.19 mmol) was obtained as the title compound in total yield of 21.0%.
¹H NMR(200MHz, CDCl₃): δ 1.65(s, 12H), 6.45-6.5(m, 12H), 6.6-6.65(m, 4H), 6.95-7.05(m, 12H), 7.15-7.2(m, 4H), 7.45-7.5(d, 8H), 7.55-7.6(m, 4H), 7.75-7.8(d, 4H), 7.85-7.9(d, 4H)

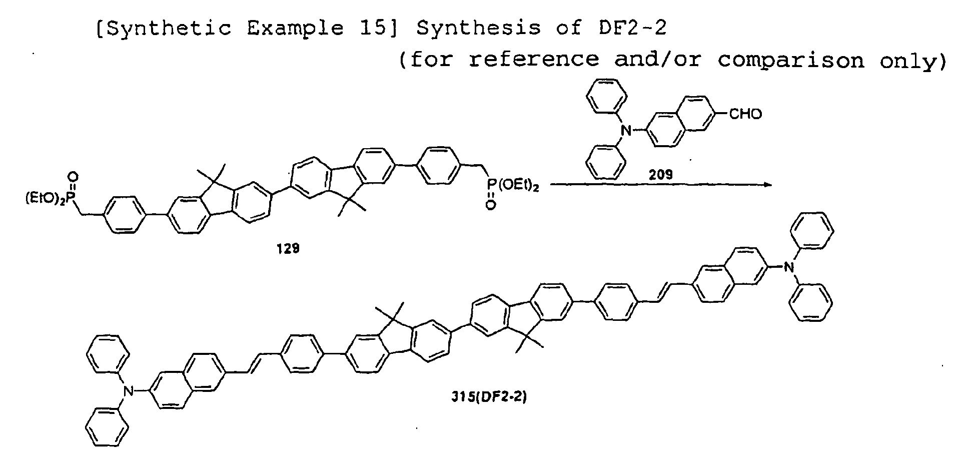

Compound (315, DF2-2) (0.86 g, 0.73 mmol) as the title compound was obtained in total yield of 17.0% according to the same procedure as Synthetic Example 14, but Compound 129 (1.0 g, 1.19 mmol), and Compound 209 (0.93 g, 2.88 mmol) instead of Compound 205 were employed.
¹H NMR(200MHz, CDCl₃) : δ 1.65(s, 12H), 6.45-6.5 (m, 8H), 6.6-6.8(m, 8H), 6.95-7.05(m, 12H), 7.35-7.6(m, 18H), 7.7-7.8(t, 6H), 7.85-7.9(d, 4H)
MS/FAB: 1176(found), 1177.56(calculated)

### [Example 1] Manufacture of OLED device by using the compound according to the present invention

An OLED device having the structure employing the electroluminescent material was manufactured.

First, a transparent electrode ITO thin film (15 Ω/□) obtained from a glass for OLED was subjected to ultrasonic washing by trichloroethylene, acetone, ethanol and distilled water, subsequently, and stored in isopronanol before use.

Then, an ITO substrate was equipped in a substrate folder of vacuum vapor deposition equipment, and 4,4',4"-tris(N,N-(2-naphthyl)-phenylamino)triphenylamine (2-TNATA) represented by following structural formula was placed in a cell of the vacuum vapor deposition equipment, which was then ventilated up to 10⁻⁶ torr of vacuum in the chamber. Electric current was applied to the cell to evaporate 2-TNATA to vapor-deposit a hole injection layer having 60 nm of thickness on the ITO substrate.

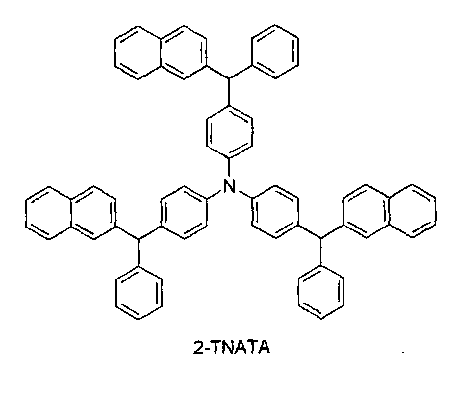

Then, to another cell of the vacuum vapor deposition equipment, charged was N,N'-bis(α-naphthyl)-N,N'-diphenyl-4,4'-diamine (NPB), and electric current was applied to the cell to evaporate NPB to vapor-deposit a hole transport layer of 20 nm of thickness on the hole injection layer.

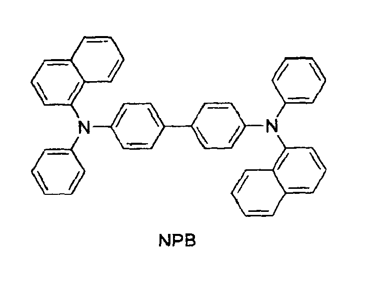

After forming the hole injection layer and hole transport layer, an electroluminescent layer was vapor-deposited thereon as follows. In one cell of the vacuum vapor deposition equipment, charged was dinaphthylanthracene (DNA) represented by following structural formula, and in another cell, an electroluminescent material of a compound according to the present invention (ex. Compound IF2-1), and an electroluminescent layer having 30 nm of thickness was vapor-deposited on said hole transport layer with the vapor deposition rate of 100:1.

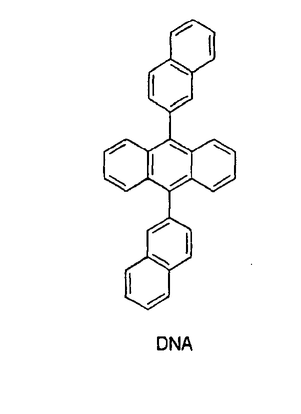

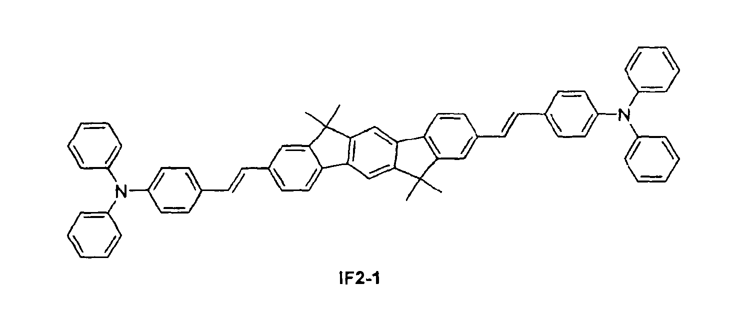

Then, tris(8-hydroxyquinoline)aluminum (III) (Alq) represented by following structural formula was vapor-deposited as an electron transport layer having 20 nm of thickness, and lithium quinolate (Liq) represented by following structural formula was vapor-deposited as an electron injection layer having from 1 to 2 nm of thickness. Thereafter, an Al cathode was vapor-deposited with 150 nm of thickness by using another vapor-deposit device to manufacture an OLED.

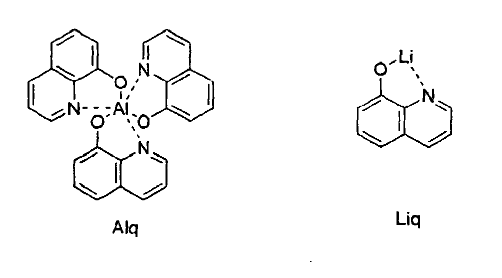

Each material employed in the OLED device was purified by vacuum sublimation under 10⁻⁶ torr, and employed as an electroluminescent material for OLED.

### [Comparative Example 1] Preparation of an OLED employing conventional electroluminescent material

A hole injection layer and hole transport layer were created according to the same procedure as described in Example 1, and dinaphthylanthracene (DNA) as a blue electroluminescent material was charged in one cell of said vapor deposition equipment, while perylene having the following structural formula in another cell as another blue electroluminescent material. Then, an electroluminescent layer with 30 nm thickness was vapor-deposited on said hole transport layer with the vapor deposition rate of 100:1.

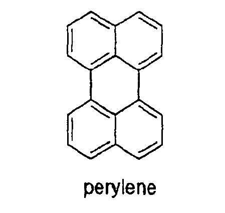

Then, an electron transport layer and an electron injection layer were vapor-deposited according to the same procedure as described in Example 1, and an Al cathode was vapor-deposited by using another vacuum vapor deposition equipment with a thickness of 150 nm, to manufacture an OLED.

### [Example 2] Electroluminescent properties of the OLED manufactured

Electroluminescent efficiencies of OLEDs comprising the organic electroluminescent compound according to the invention prepared from Example 1 and the conventional electroluminescent compound prepared from Comparative Example 1 were measured at 500 cd/m² and 2,000 cd/m², respectively, of which the results are shown in Table 1. Since the luminescent properties in the range of low luminance and those applied on a panel are very important in case of blue electroluminescent material, in particular, the data of luminance of about 2,000 cd/m² was established as the standard in order to reflect those properties.

**[Table 1]**

| No. | EL Material 1 | EL Material 2 | EL (nm) | EL Efficiency peak (cd/A) | | Color coordinate | | EL Efficiency/Y |
|---|---|---|---|---|---|---|---|---|
| | | | | @500 cd/m² | @2,000 cd/m² | X | Y | |
| 1 | DNA | IF1-1 | 451 | 3.67 | 2.89 | 0.155 | 0.137 | 26.8 |
| 2 | DNA | IF1-2 | 435 | 2.90 | 2.04 | 0.151 | 0.092 | 31.5 |
| 3 | DNA | IFI-3 | 435 | 3.01 | 2.32 | 0.151 | 0.094 | 32.0 |
| 4 | DNA | IFI-4 | 438 | 2. 95 | 2.20 | 0.151 | 0.093 | 31.7 |
| 5 | DNA | IF2-1 | 465 | 11.27 | 12.81 | 0.154 | 0.195 | 65.7 |
| 6 | DNA | IF2-2 | 465 | 11.71 | 12.37 | 0.166 | 0.202 | 61.2 |
| 7 | DNA | IF2-3 | 465 | 10.33 | 12.87 | 0.169 | 0.208 | 61.9 |
| 8 | DNA | IF2-4 | 461 | 8.02 | 10.90 | 0.158 | 0.192 | 56.8 |
| 9* | DNA | DF1-1 | 456 | 7.70 | 8.35 | 0.149 | 0.146 | 57.2 |
| 10* | DNA | DF1-2 | 456 | 7.07 | 8.41 | 0.158 | 0.155 | 54.3 |
| 11* | DNA | DF1-3 | 455 | 6.73 | 7.81 | 0.147 | 0.128 | 61.0 |
| 12 | DNA | IF3-1 | 453 | 6.61 | 6.76 | 0.155 | 0.132 | 51.2 |
| 13 | DNA | IF3-2 | 452 | 5.60 | 5.80 | 0.150 | 0.126 | 44.5 |
| 14* | DNA | DF2-1 | 450 | 5.11 | 5.09 | 0.168 | 0.104 | 49.1 |
| 15* | DNA | DF2-2 | 448 | 4.50 | 4.62 | 0.157 | 0.103 | 44.8 |
| Comp. 1 | DNA | Perylene | 456, 484 | 4.45 | 3.62 | 0.160 | 0.200 | 22.3 |

| | | | | | | | | |
|---|---|---|---|---|---|---|---|---|
| * for comparison and/or reference only. | | | | | | | | |

As can be seen from Table 1, the OLED device employing the organic electroluminescent compounds as the electroluminescent material was compared to the OLED device of Comparative Example which employs widely known DNA:perylene as a conventional electroluminescent material, on the basis of "luminous efficiency/Y" value which shows similar tendency to proton efficiency. As the result, the OLED device employing the organic electroluminescent compound according to the present invention showed higher "luminous efficiency/Y" value than that of Comparative Example.

In view of the fact that the organic electroluminescent compound according to the invention showed higher "luminous efficiency/Y" value, it is found that indenofluorene which is the basic skeletal of the organic electroluminescent compounds of the present invention is a material having high proton efficiency. In addition, it is found that the organic electroluminescent compounds of the present invention can realize higher efficiency and color purity as compared to conventional electroluminescent compounds. In particular, in case of the series of IF2 not part of invention and IF3, the "luminous efficiency/Y" value was enhanced 3-folds or more as compared to conventional electroluminescent compound.

In general, in case of a structure comprising a double bond primarily based on stilbene, noticeable enhancement of performances was confirmed. It is assumed that the enhancement of performances in case that the molecular structure wherein the chemical bonds are formed via double bond(s) rather than those wherein only aromatics are simply connected is due to improvement of overlaps between the orbitals of respective aromatic ring in the molecular structure.

From Table 1, it is confirmed that "luminous efficiency/Y" value of the compounds of the invention showed at least two-folds of improvement of the performance as compared to conventional materials, and this comes from the effect of indenofluorene and difluorene skeletal of the present invention to improve by far the valuable properties.

As described above, the organic electroluminescent compounds according to the present invention can be employed as a blue electroluminescent material of high efficiency, thereby having great advantages in terms of luminance of OLED, power consumption and life as compared to conventional ones.

### [Industrial Applicability]

The organic electroluminescent compounds according to the present invention have good electroluminescent efficiency and excellent life properties, thereby providing OLED having very long lifetime of operation.

## Claims

1. An organic electroluminescent compound represented by Chemical Formula 1 : 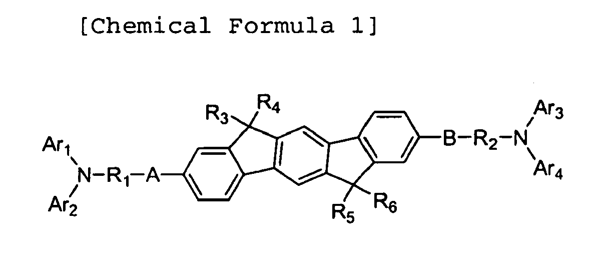 A and B independently represent a chemical bond, 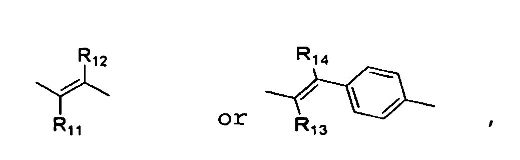
R₁ and R₂ independently represent an aromatic ring or a fused multi-cyclic aromatic ring having two or more aromatic rings,
R₃ through R₆ independently represent a linear or branched C₁-C₂₀ alkyl group with or without halogen substituent(s), a C₅-C₈ cycloalkyl group, or an aromatic group with or without halogen substituent(s),
R₁₁ through R₁₄ independently represent a hydrogen, a C₁-C₈ alkyl group, a C₅-C₈ cycloalkyl group or an aromatic group with or without halogen substituent(s),
Ar₁ through Ar₄ independently represent an aromatic ring or a fused multi-cyclic aromatic ring having two or more aromatic rings.

2. An organic electroluminescent compound according to claim 1, which is represented by one of Chemical Formulas 2, 3 and 5: 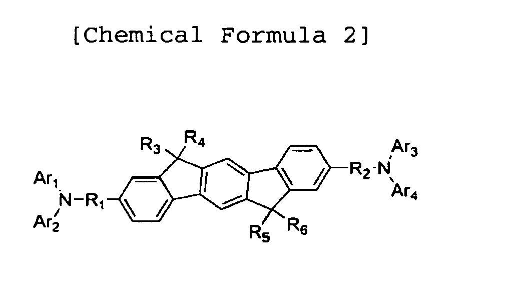 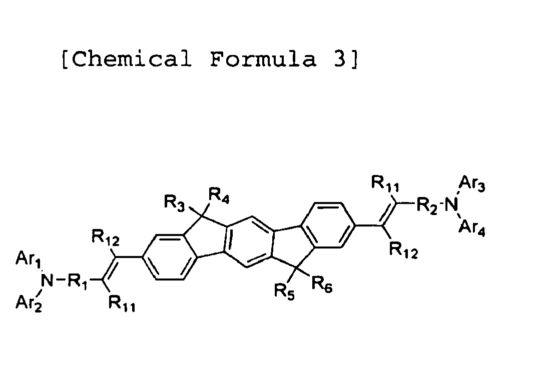 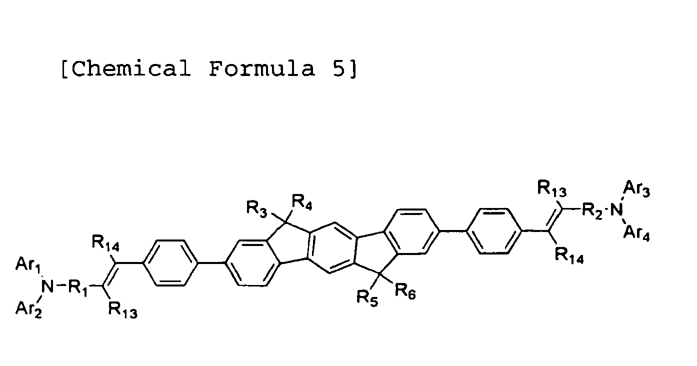
wherein, R₁ and R₂ independently represent an aromatic group or a fused multi-cyclic aromatic ring having two or more aromatic rings,
R₃ through R₆ independently represent a linear or branched C₁-C₂₀ alkyl group with or without halogen substituent(s), a C₅-C₈ cycloalkyl group, or an aromatic group with or without halogen substituent(s),
R₁₁ through R₁₄ independently represent hydrogen, a C₁-C₈ alkyl group, a C₅-C₈ cycloalkyl group or an aromatic group with or without halogen substituent(s), and
Ar₁ through Ar₄ independently represent an aromatic ring or a fused multi-cyclic aromatic ring having two or more aromatic rings.

3. An organic electroluminescent compound according to claim 2, wherein R₁ and R₂ in Chemical Formulas 2, 3 and 5 are selected from phenylene, naphthalene, anthracene, naphthacene, pyrene, fluorene and biphenyl,
R₃ through R₆ represent methyl, ethyl, n-propyl, i-propyl, n-butyl, i-butyl, t-butyl, n-pentyl, i-amyl, n-hexyl, n-heptyl, n-octyl, 2-ethylhexyl, n-nonyl, trifluoromethyl, pentafluoroethyl, cyclopentyl, cyclohexyl, cycloheptyl, cyclooctyl, phenyl, tolyl, 1-naphthyl, 2-naphthyl, 2-fluorophenyl or 4-fluorophenyl,
R₁₁ through R₁₄ represent a hydrogen, methyl, ethyl, n-propyl, i-propyl, n-butyl, i-butyl, t-butyl, n-pentyl, n-hexyl, n-heptyl, n-octyl, cyclopentyl, cyclohexyl, cycloheptyl, cyclooctyl, phenyl, tolyl, 1-naphthyl, 2-naphthyl, 2-fluorophenyl or 4-fluorophenyl, and
Ar₁ through Ar₄ represent phenyl, tolyl, xylyl, pyridyl, biphenyl, naphthyl, anthryl, phenanthryl, naphthacenyl, acenaphthenyl, pyrenyl, fluorenyl or perylenyl.

4. An organic electroluminescent compound according to claim 3, which is selected from the compounds represented by following chemical formulas: 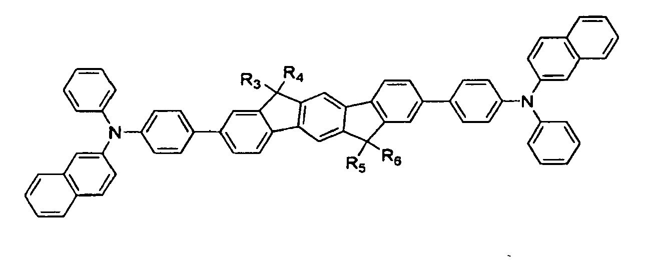 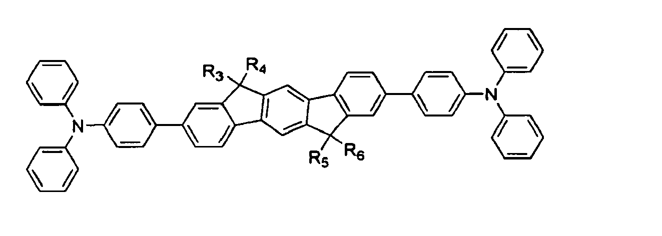 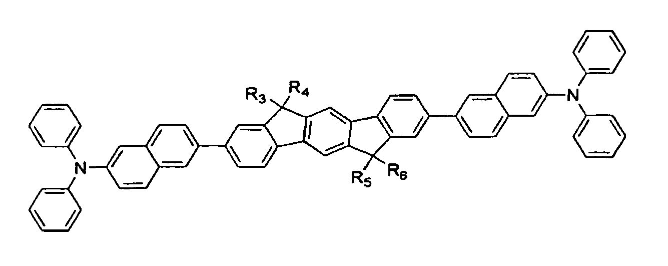 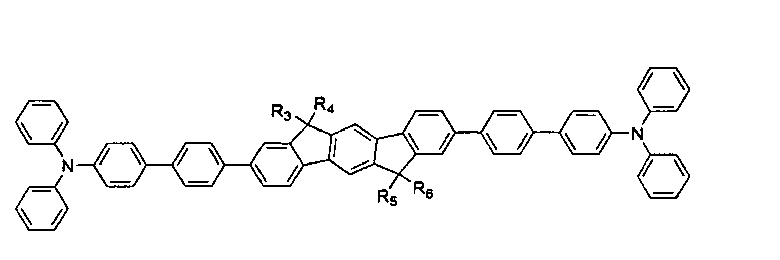 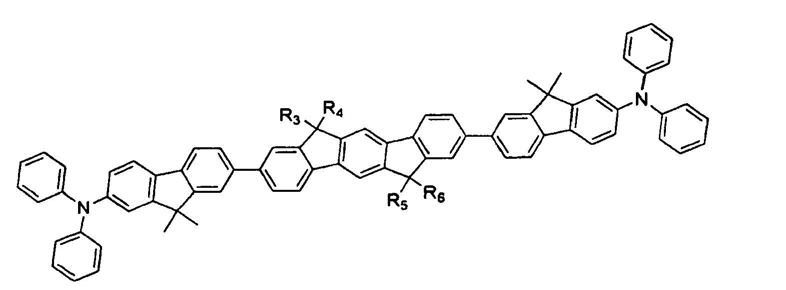 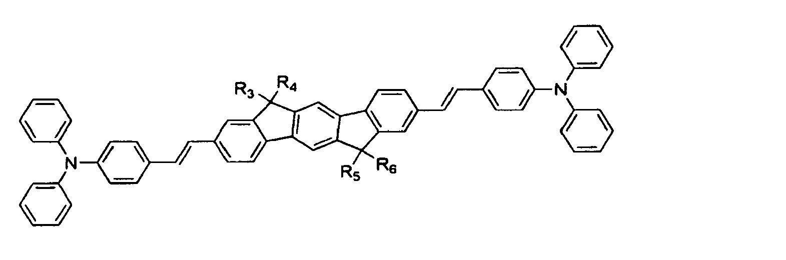 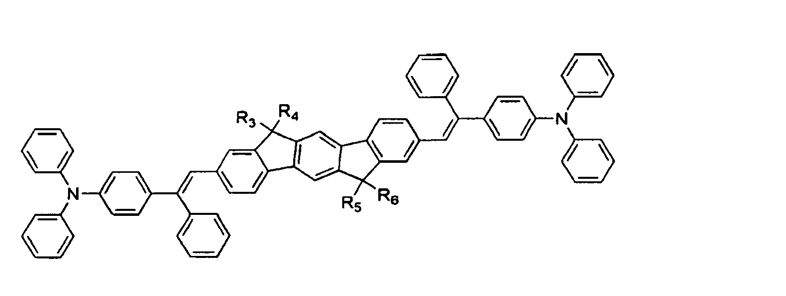 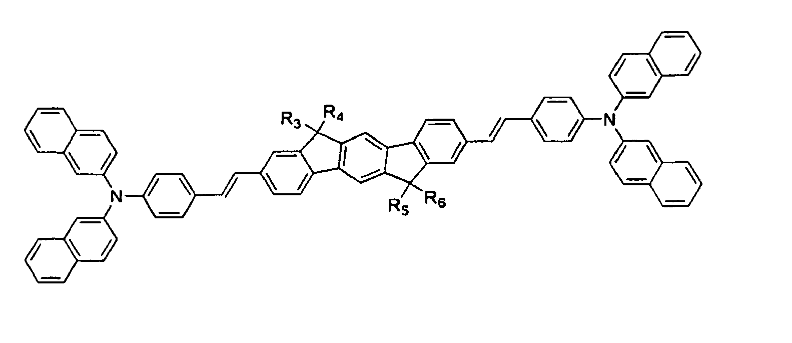 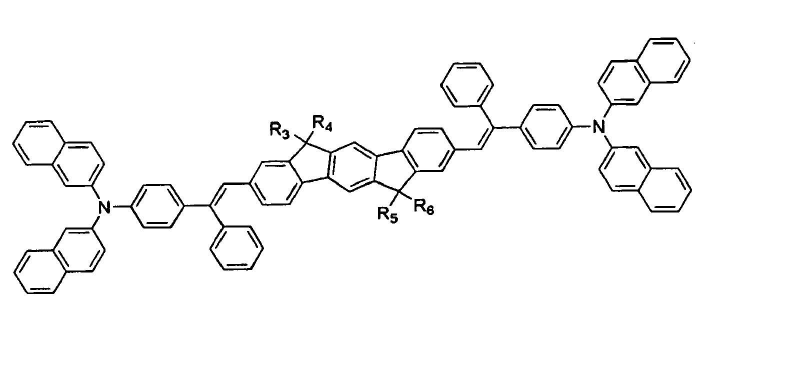 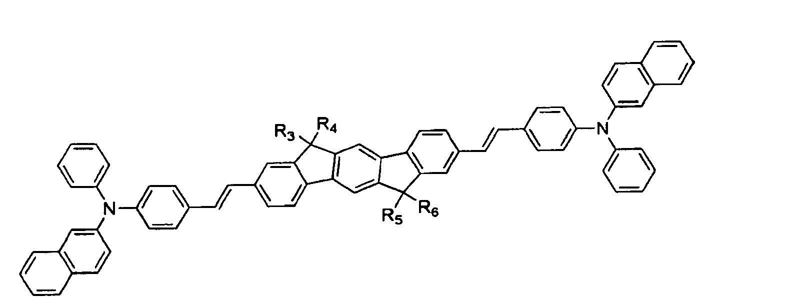 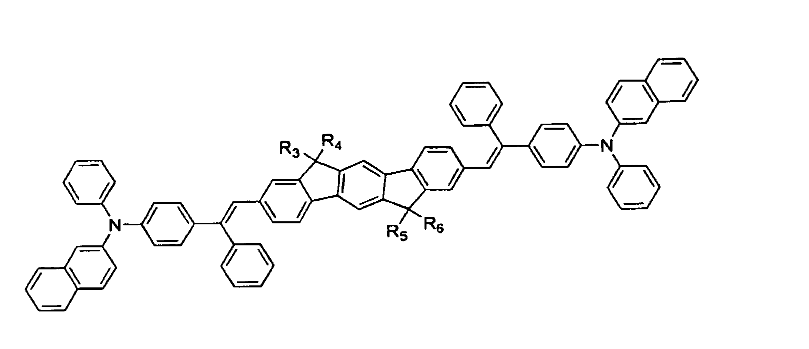 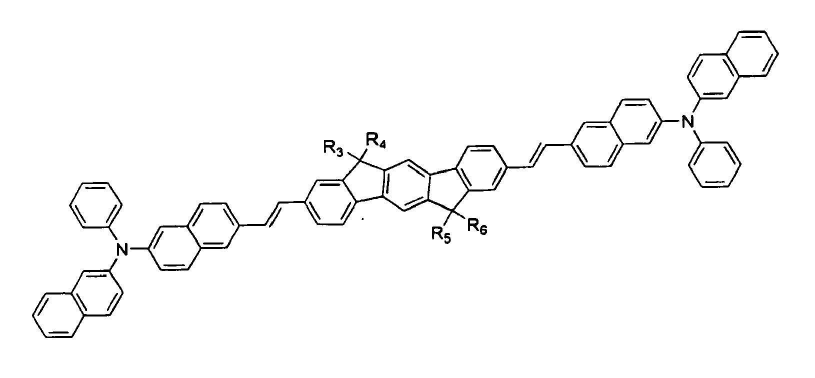 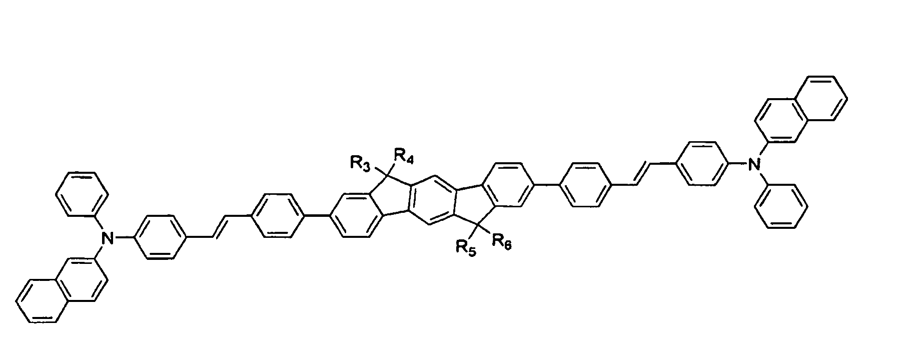 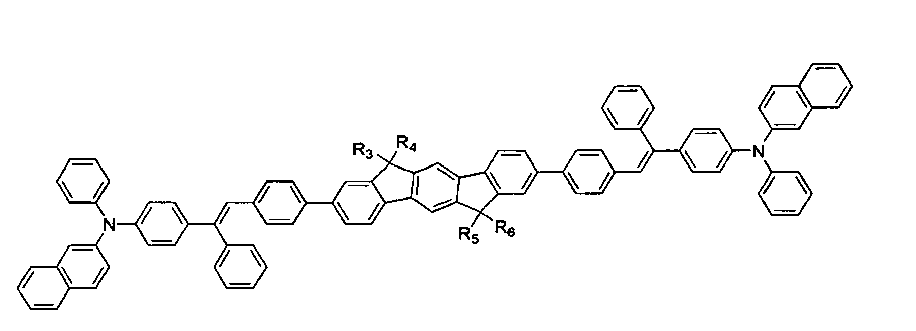 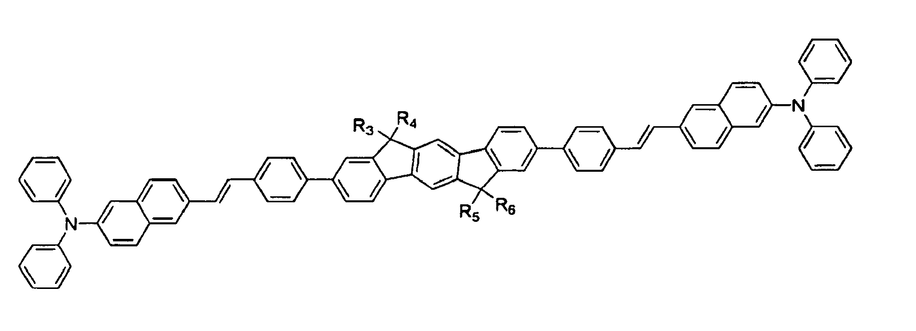 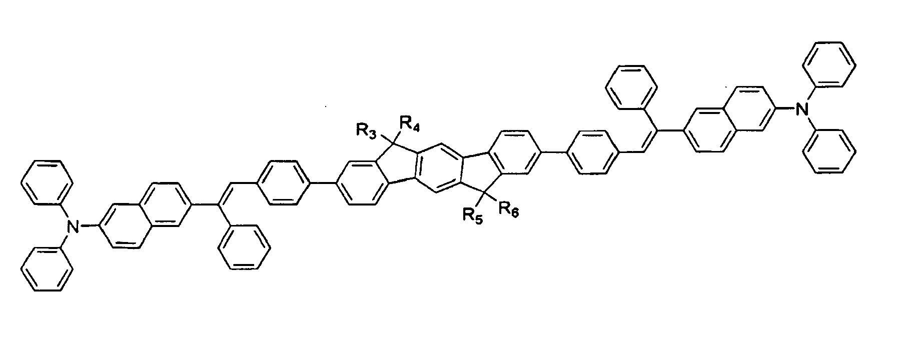 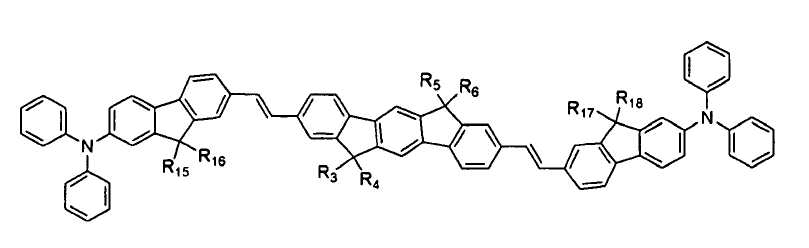 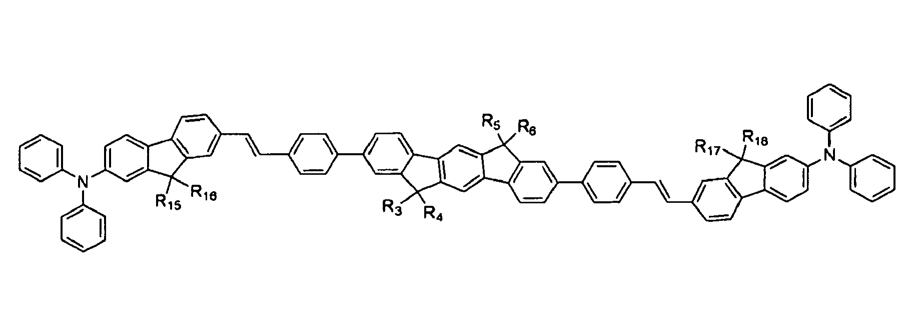 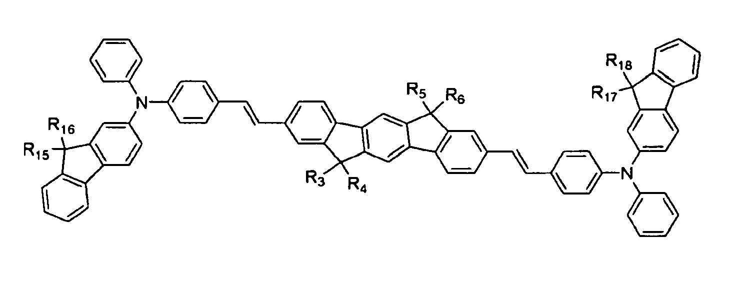 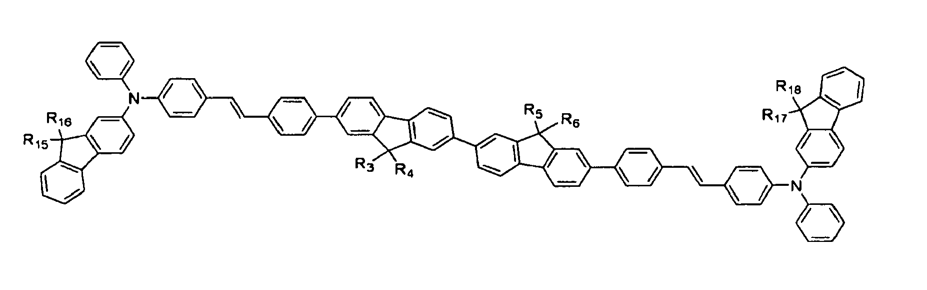 wherein, R₃ through R₆ represent methyl group or ethyl group, and R₁₅ to R₁₈ represent methyl group, ethyl group or phenyl group.

5. An organic electroluminescent device comprising an anode; a cathode; and an organic electroluminescent compound according to any one of claims 1 to 4 between the anode and the cathode.

## Patentansprüche

1. Organische Elektrolumineszenzverbindung, die durch die chemische Formel 1 dargestellt wird: 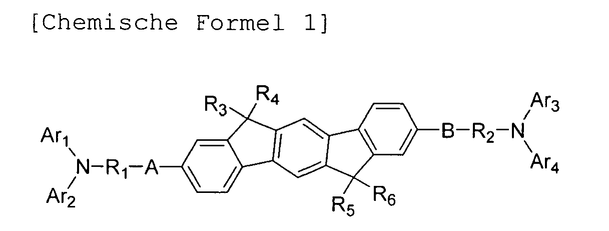 worin A und B unabhängig eine chemische Bindung, 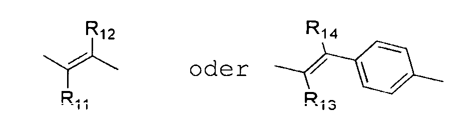 darstellen,
R₁ und R₂ unabhängig einen aromatischen Ring oder einen kondensierten multicyclischen aromatischen Ring, der zwei oder mehr aromatische Ringe hat, darstellen,
R₃ bis R₆ unabhängig eine lineare oder verzweigte C₁-C₂-Alkylgruppe mit oder ohne Halogensubstituent(en), eine C₅-C₈-Cycloalkylgruppe oder eine aromatische Gruppe mit oder ohne Halogensubstituent(en) darstellen,
R₁₁ bis R₁₄ unabhängig Wasserstoff, eine C₁-C₈-Alkylgruppe, eine C₅-C₈-Cycloalkylgruppe oder eine aromatische Gruppe mit oder ohne Halogensubstituent(en) darstellen,
Ar₁ bis Ar₄ unabhängig einen aromatischen Ring oder einen kondensierten multicyclischen aromatischen Ring, der zwei oder mehr aromatische Ringe hat, darstellen.

2. Organische Elektrolumineszenzverbindung nach Anspruch 1, welche durch eine der chemischen Formeln 2, 3 und 5 dargestellt wird: 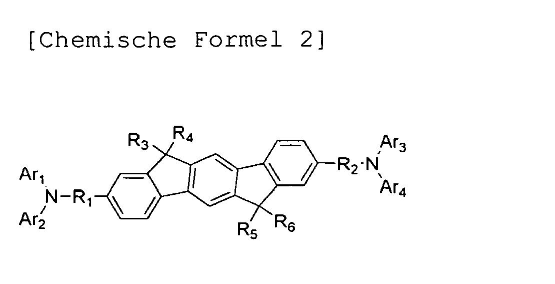 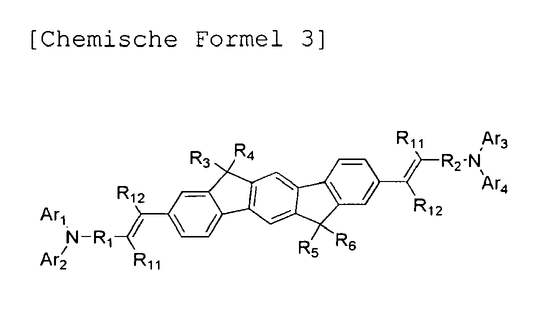 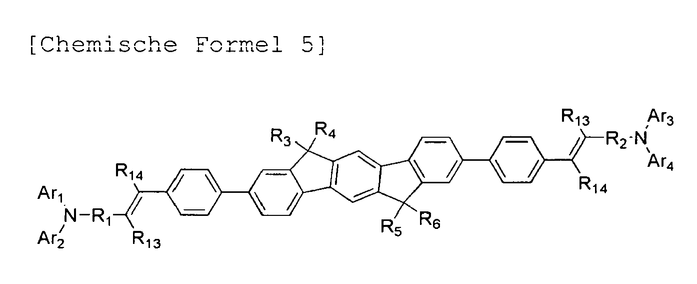
worin R₁ und R₂ unabhängig einen aromatischen Ring oder einen kondensierten multicyclischen aromatischen Ring, der zwei oder mehr aromatische Ringe hat, darstellen,
R₃ bis R₆ unabhängig eine lineare oder verzweigte C₁-C₂₀-Alkylgruppe mit oder ohne Halogensubstituent(en), eine C₅-C₈-Cycloalkylgruppe oder einen aromatischen Ring mit oder ohne Halogensubstituent(en) darstellen,
R₁₁ bis R₁₄ unabhängig Wasserstoff, eine C₁-C₈-Alkylgruppe, eine C₅-C₈-Cycloalkylgruppe oder eine aromatische Gruppe mit oder ohne Halogensubstituent(en) darstellen und
Ar₁ bis Ar₄ unabhängig einen aromatischen Ring oder einen kondensierten multicyclischen aromatischen Ring, der 2 oder mehr aromatische Ringe hat, darstellen.

3. Organische Elektrolumineszenzverbindung nach Anspruch 2, wobei R₁ und R₂ in den chemischen Formeln 2, 3 und 5 aus Phenylen, Naphthalen, Anthracen, Naphthacen, Pyren, Fluoren und Biphenyl ausgewählt sind,
R₃ bis R₆ Methyl, Ethyl, n-Propyl, i-Propyl, n-Butyl, i-Butyl, t-Buyl, n-Pentyl, i-Amyl, n-Hexyl, n-Heptyl, n-Octyl, 2-Ethylhexyl, n-Nonyl, Trifluormethyl, Pentafluorethyl, Cyclopentyl, Cyclohexyl, Cycloheptyl, Cyclooctyl, Phenyl, Tolyl, 1-Naphthyl, 2-Naphthyl, 2-Fluorphenyl oder 4-Fluorphenyl darstellen,
R₁₁ bis R₁₄ ein Wasserstoff, Methyl, Ethyl, n-Propyl, i-Propyl, n-Butyl, i-Butyl, t-Butyl, n-Pentyl, n-Hexyl, n-Heptyl, n-Octyl, Cyclopentyl, Cyclohexyl, Cycloheptyl, Cyclooctyl, Phenyl, Tolyl, 1-Naphthyl, 2-Naphthyl, 2-Fluorphenyl oder 4-Fluorphenyl darstellen und
Ar₁ bis Ar₄ Phenyl, Tolyl, Xylyl, Pyridyl, Biphenyl, Naphthyl, Anthryl, Phenanthryl, Naphthacenyl, Acenaphthenyl, Pyrenyl, Fluorenyl oder Perylenyl darstellen.

4. Organische Elektrolumineszenzverbindung nach Anspruch 3, welche aus den Verbindungen ausgewählt ist, die durch die folgenden chemischen Formeln dargestellt werden: 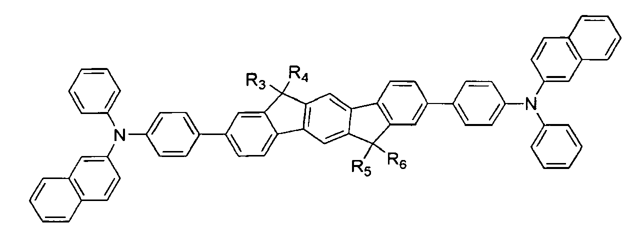 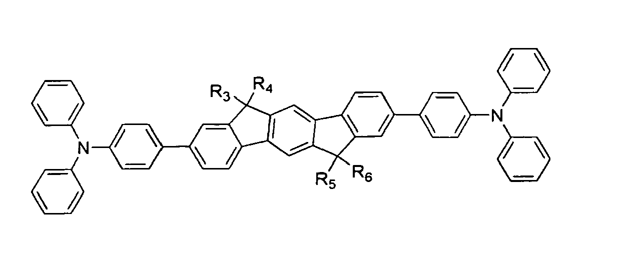 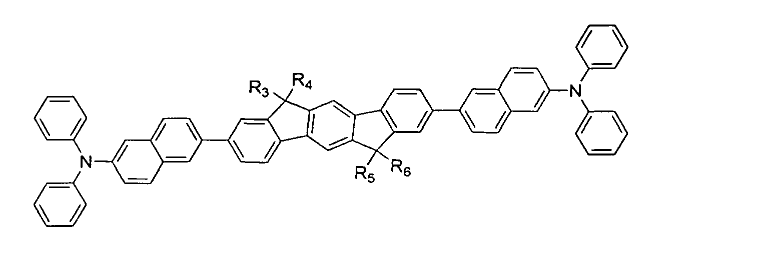 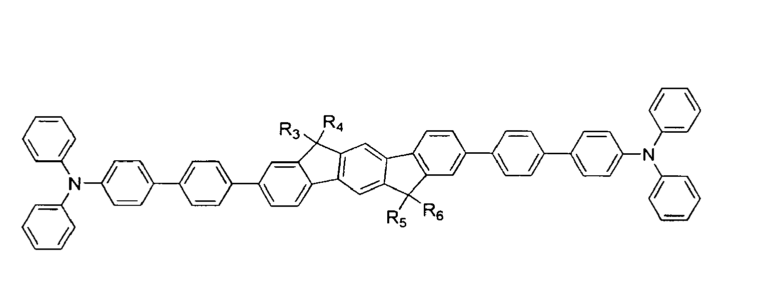 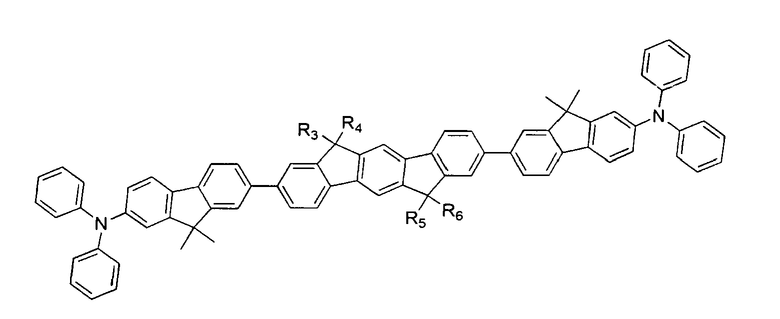 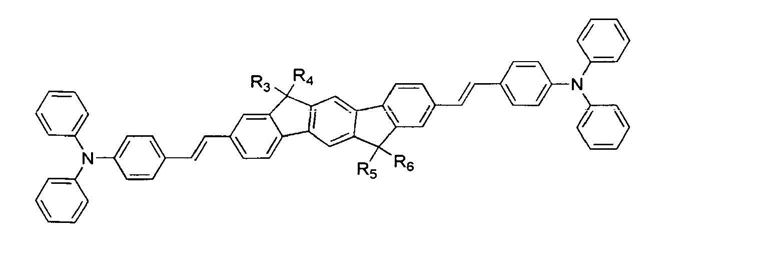 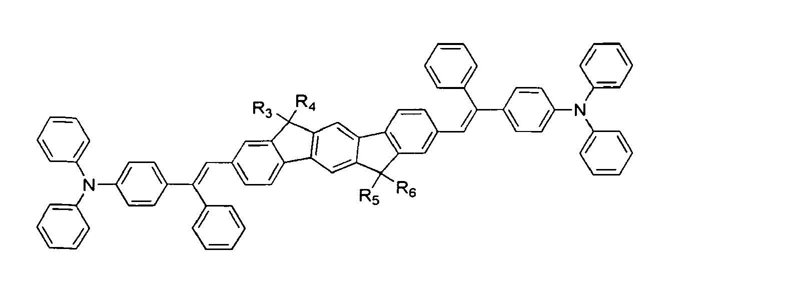 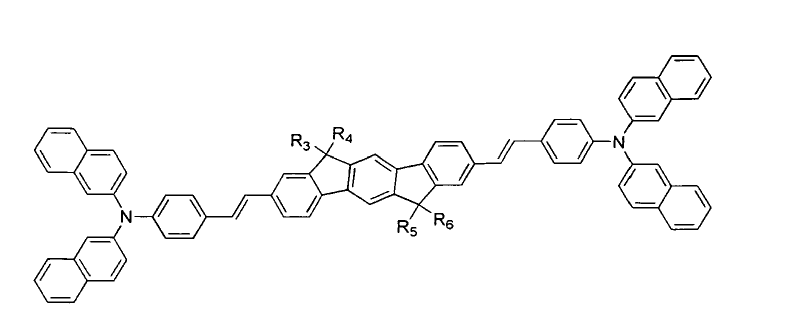 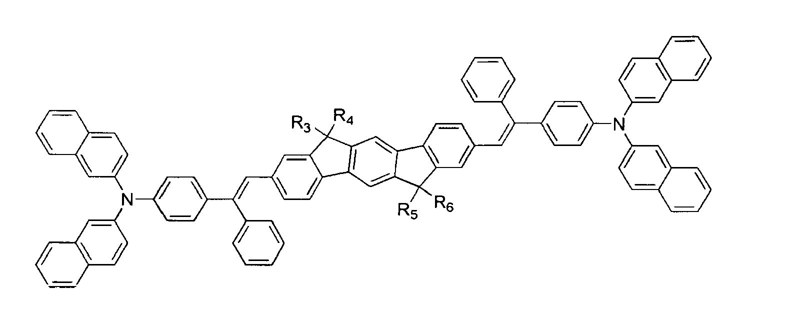 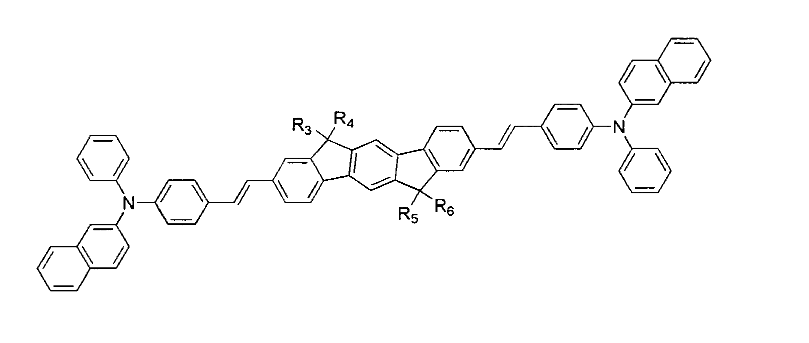 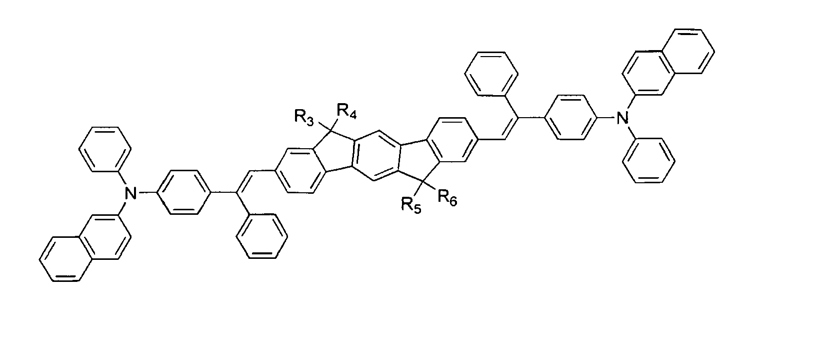 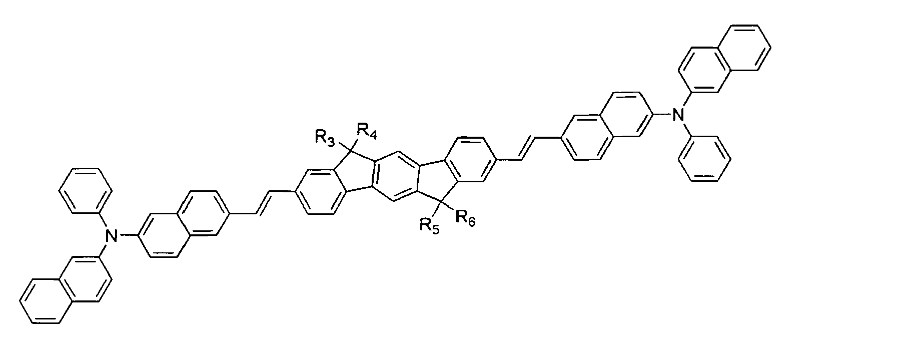 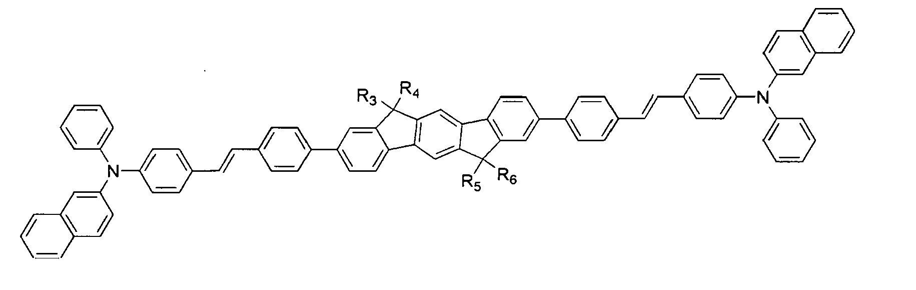 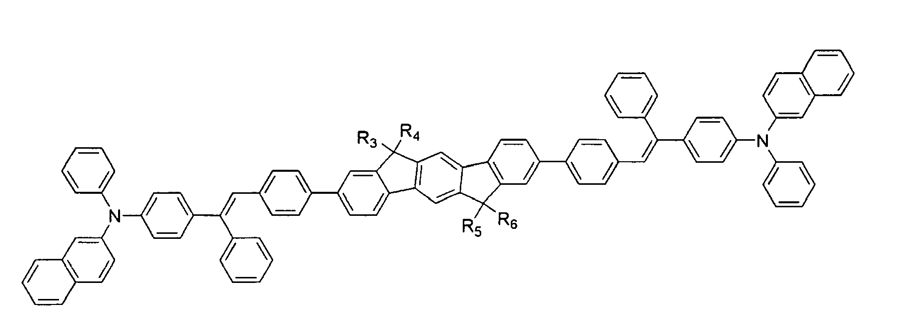 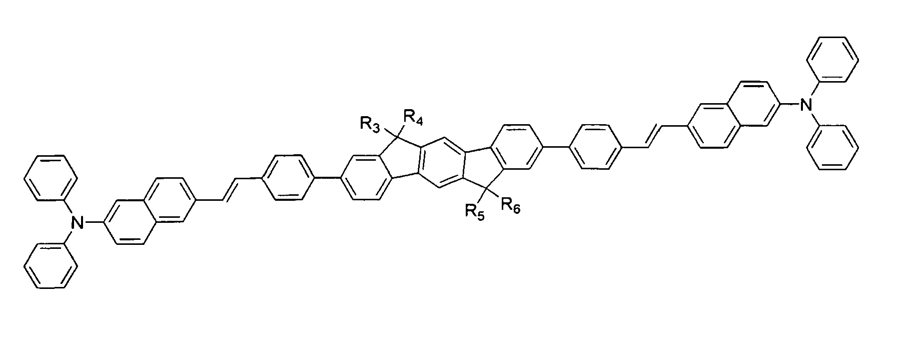 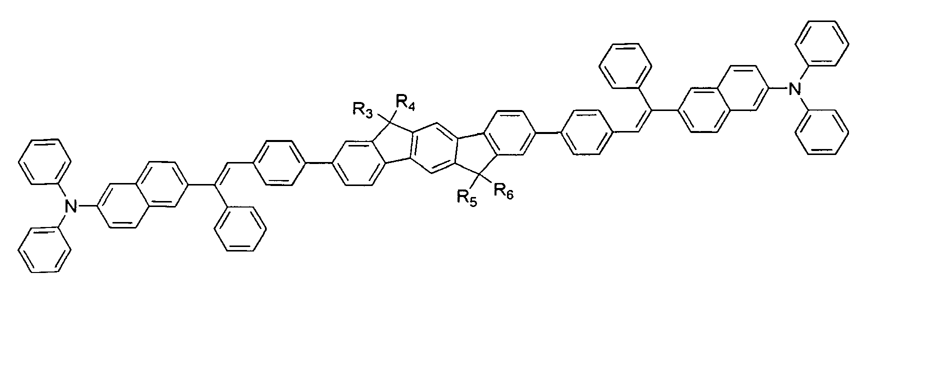 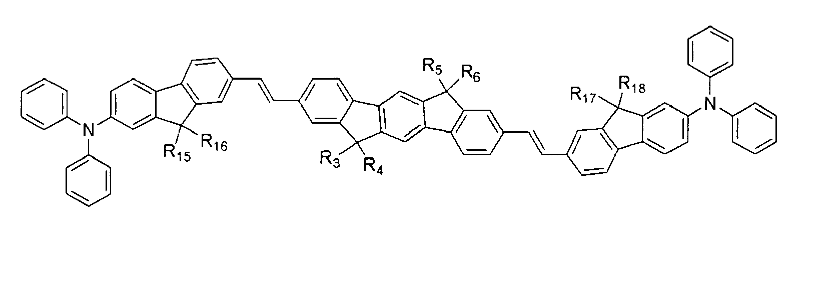 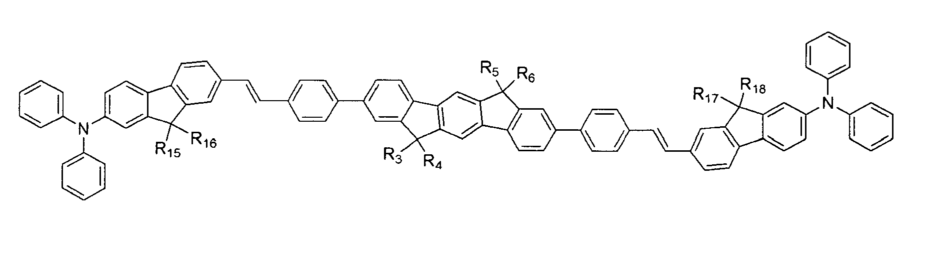 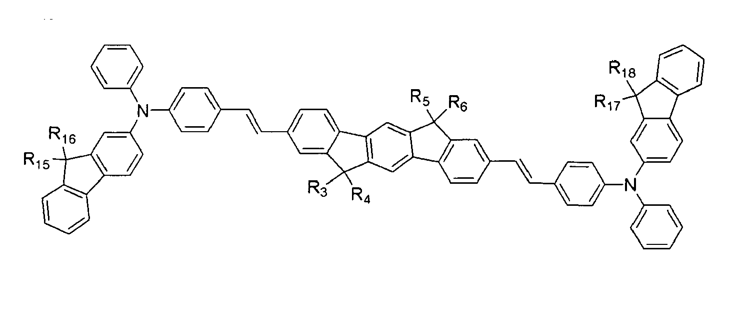 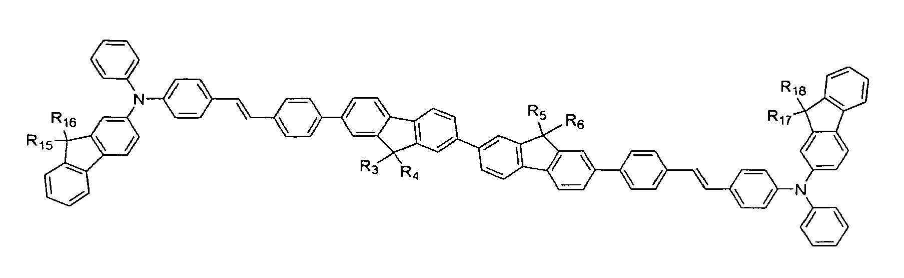 worin R₃ bis R₆ eine Methylgruppe oder Ethylgruppe darstellen und R₁₅ bis R₁₈ eine Methylgruppe, Ethylgruppe oder Phenylgruppe darstellen.

5. Organische Elektrolumineszenzvorrichtung, umfassend eine Anode, eine Kathode und eine organische Elektrolumineszenzverbindung nach einem der Ansprüche 1 bis 4 zwischen der Anode und der Kathode.

## Revendications

1. Composé électroluminescent organique représenté par la formule chimique 1: 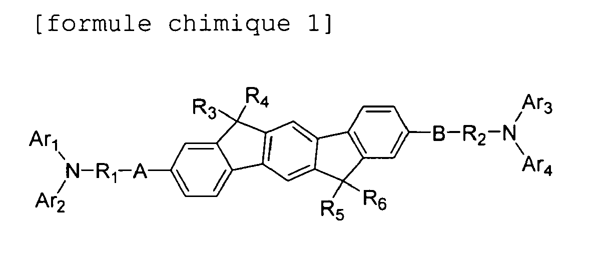 A et B représentent indépendamment une liaison chimique, 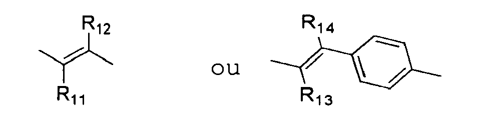
R₁ et R₂ représentent indépendamment un cycle aromatique ou un cycle aromatique condensé multicyclique ayant deux ou plusieurs cycles aromatiques;
R₃ à R₆ représentent indépendamment un groupe alkyle linéaire ou ramifié en C₁-C₂₀ avec ou sans substituant (s) d'halogène, un groupe cycloalkyle en C₅-C₈ ou un groupe aromatique avec ou sans substituant(s) d'halogène;
R₁₁ à R₁₄ représentent indépendamment l'hydrogène, un groupe alkyle en C₁-C₈, un groupe cycloalkyle en C₅-C₈ ou un groupe aromatique avec ou sans substituant(s) d'halogène;
Ar₁ à Ar₄ représentent indépendamment un cycle aromatique ou un cycle aromatique condensé multicyclique ayant deux ou plusieurs cycles aromatiques.

2. Composé électroluminescent organique selon la revendication 1, qui est représenté par l'une des formules chimiques 2, 3 et 5: 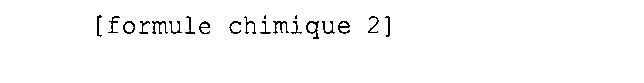 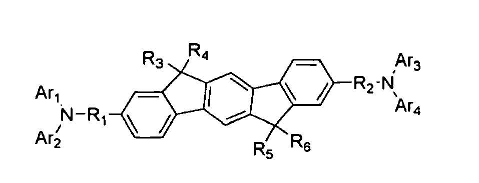 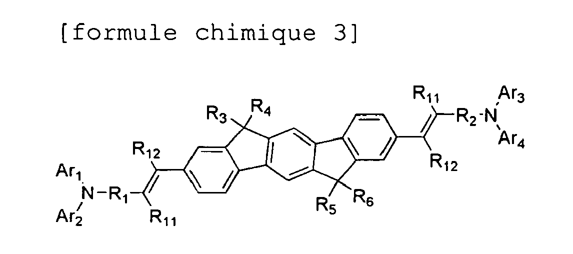 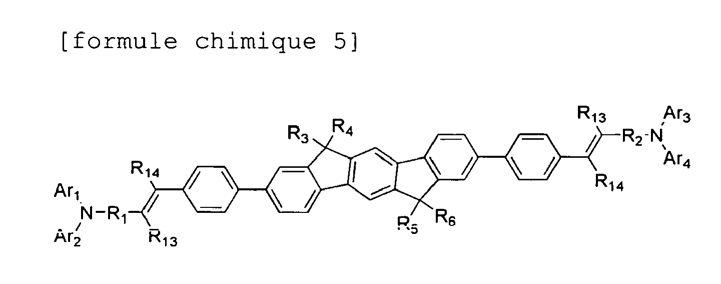 où
R₁ et R₂ représentent indépendamment un groupe aromatique ou un cycle aromatique condensé multicyclique ayant deux ou plusieurs cycles aromatiques;
R₃ à R₆ représentent indépendamment un groupe alkyle linéaire ou ramifié en C₁-C₂₀ avec ou sans substituant(s) d'halogène, un groupe cycloalkyle en C₅-C₈ ou un groupe aromatique avec ou sans substituant(s) d'halogène;
R₁₁ à R₁₄ représentent indépendamment l'hydrogène, un groupe alkyle en C₁-C₈, un groupe cycloalkyle en C₅-C₈ ou un groupe aromatique avec ou sans substituant(s) d'halogène et
Ar₁ à Ar₄ représentent indépendamment un cycle aromatique ou un cycle aromatique condensé multicyclique ayant deux ou plusieurs cycles aromatiques.

3. Composé électroluminescent organique selon la revendication 2,
dans lequel
R₁ et R₂ dans les formules chimiques 2, 3 et 5 sont choisis parmi le phénylène, le naphtylène, l'antracène, le pyrène, le fluorène et le biphényle,
R₃ à R₆ représentent méthyle, éthyle, n-propyle, i-propyle, n-butyle, i-butyle, t-butyle, n-pentyle, i-amyle, n-hexyle, n-heptyle, n-octyle, 2-éthylhexyle, n-nonyle, trifluorométhyle, pentafuoroéthyle, cyclopentyle, cyclohexyle, cycloheptyle, cyclooctyle, phényle, tolyle, 1-naphtyle, 2-naphtyle, 2-fluorophényle ou 4-fluorophényle;
R₁₁ à R₁₄ représentent l'hydrogène, méthyle, éthyle, n-propyle, i-propyle, n-butyle, i-butyle, t-butyle, n-pentyle, n-hexyle,
R₁₁ à R₁₄ représentent l'hydrogène, méthyle, éthyle, n-propyle, i-propyle, n-butyle, i-butyle, t-butyle, n-pentyle, n-hexyle, n-heptyle, n-octyle, cyclopentyle, cycohexyle, cycloheptyle, cyclooctyle, phényle, tolyle, 1-naphtyle, 2-naphtyle, 2-fluorophényle ou 4-fluorophényle et
Ar₁ à Ar₄ représentent phényle, tolyle, xylyle, pyridyle, biphényle, naphtyle, anthryle, phénanthryle, naphtacényle, acénaphtényle, pyrényle, fluorényle ou perylényle.

4. Composé électroluminescent organique selon la revendication 3, qui est choisi parmi les composés représentés par les formules chimiques suivantes: 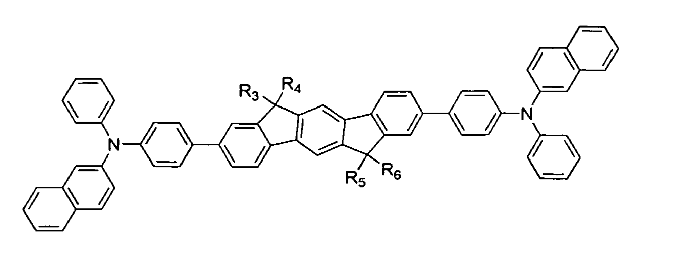 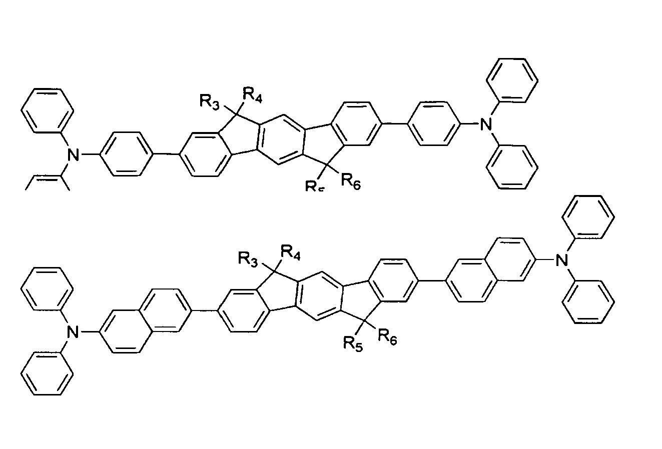 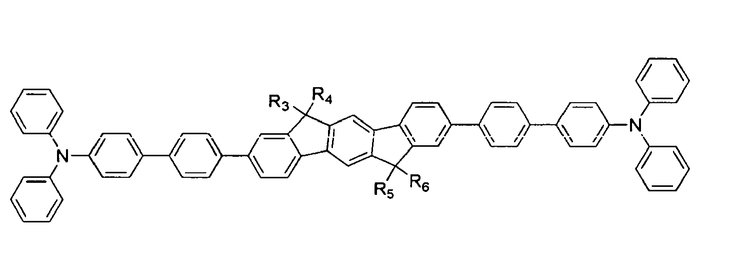 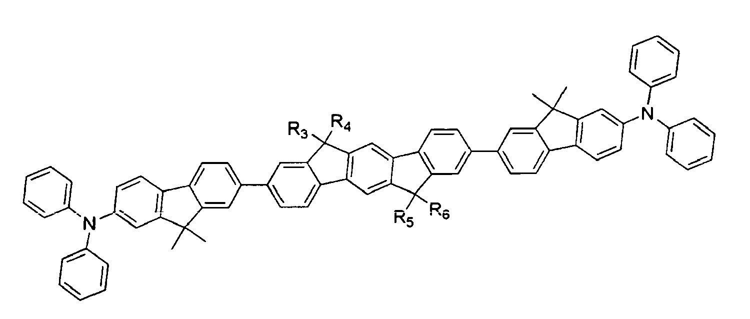 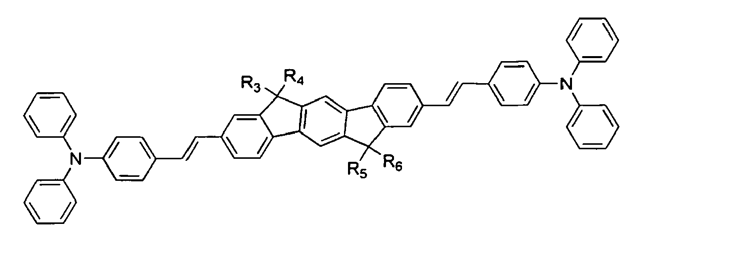 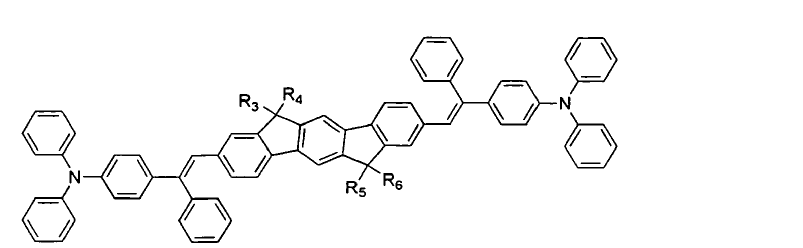 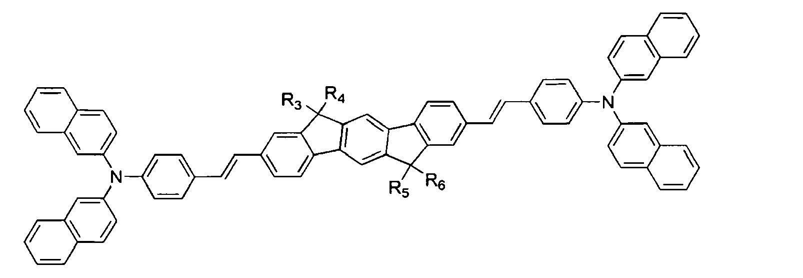 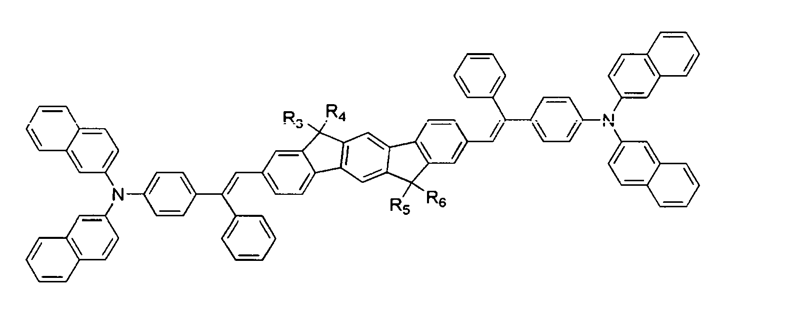 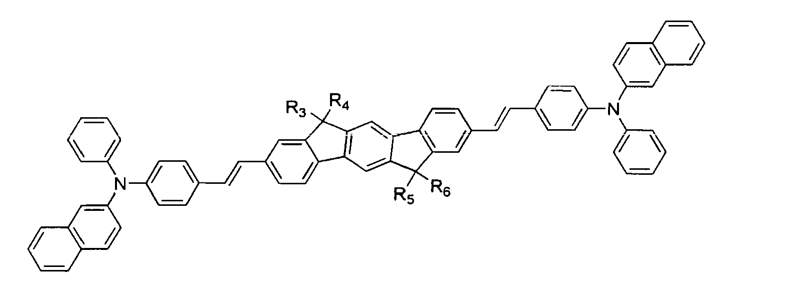 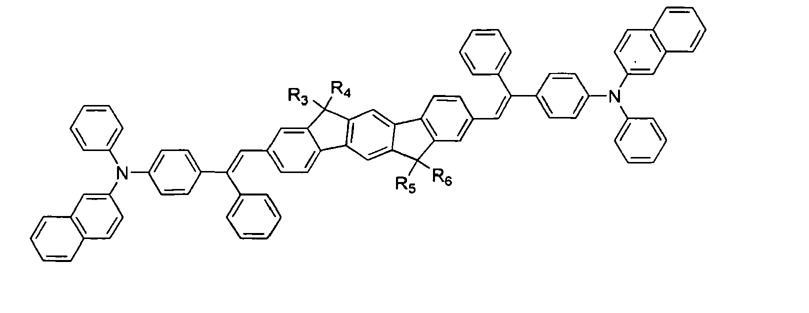 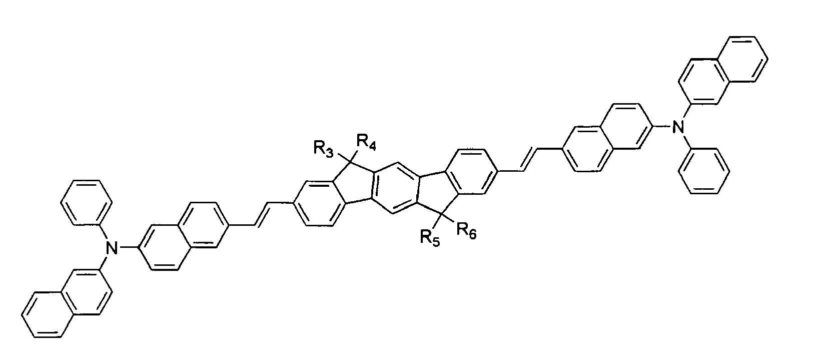 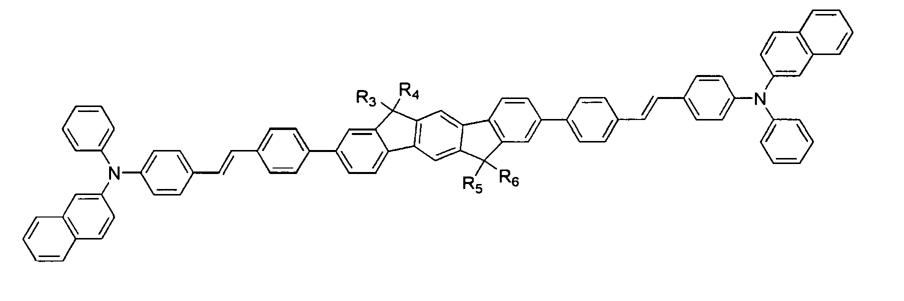 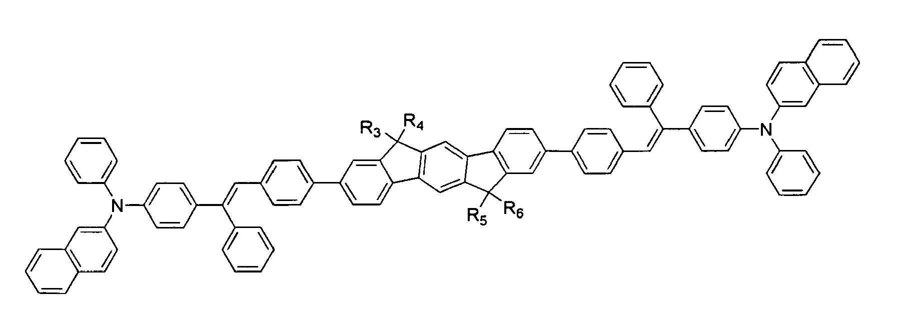 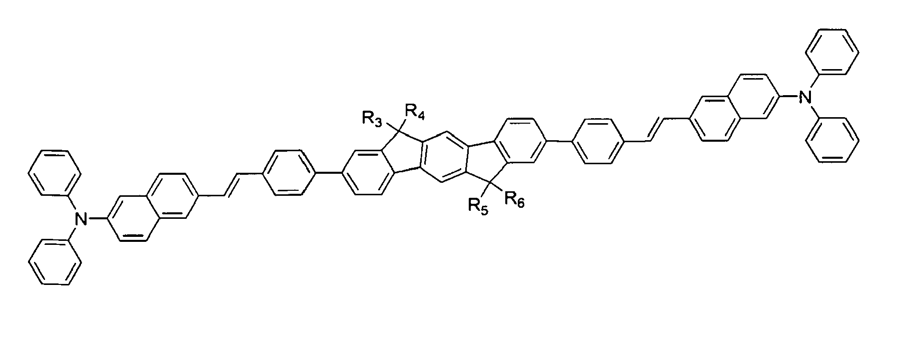 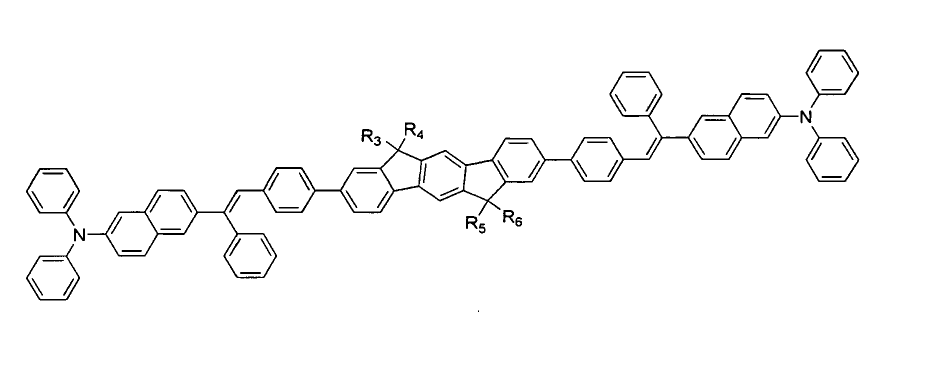 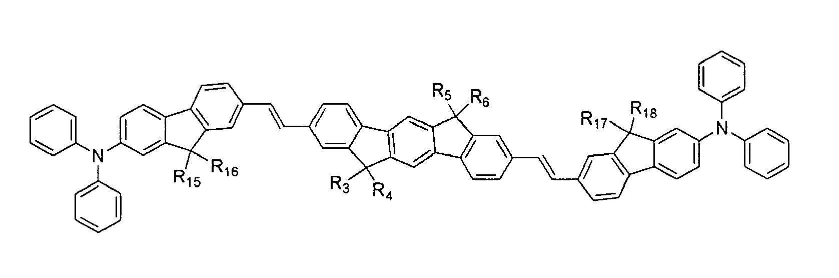 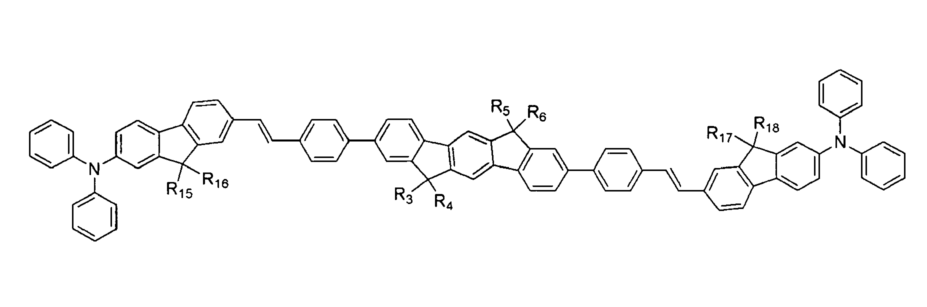 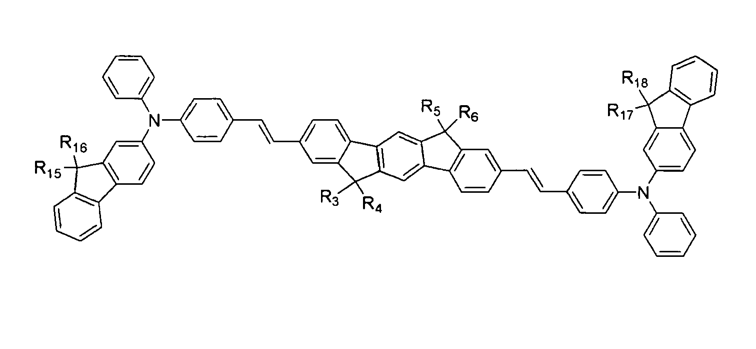 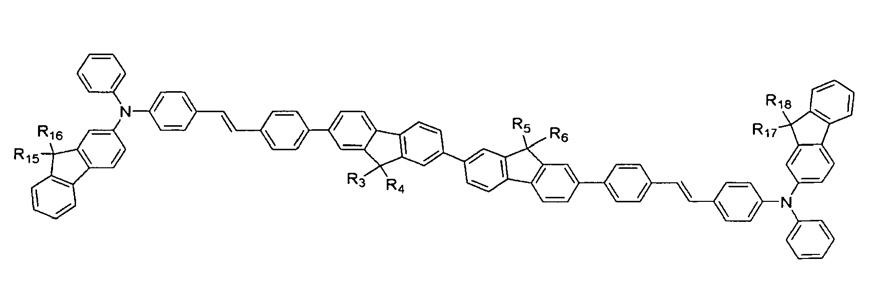 dans lequel R₃ à R₆ représentent un groupe méthyle ou un groupe éthyle, et R₁₅ à R₁₈ représentent un goupe méthyle, un groupe éthyle ou un groupe phényle.

5. Dispositif électroluminescent organique comprenant une anode, une cathode et un composé électroluminescent organique selon l'une quelconque des revendications 1 à 4 entre l'anode et la cathode.
